# EUROPÄISCHE PATENTSCHRIFT

(11) **EP 2 498 315 B1**
(45) Veröffentlichungstag und Bekanntmachung des Hinweises auf die Patenterteilung: **01.02.2017**
(21) Anmeldenummer: 12001675.3
(22) Anmeldetag: 12.03.2012
(51) Int. Cl.: H01L 51/46

(54) **Organische Solarzelle**
Organic solar cell
Cellule solaire organique

(30) Priorität: 11.03.2011 DE 102011013897
(43) Veröffentlichungstag der Anmeldung: 12.09.2012
(73) Patentinhaber: Technische Universität Dresden, 01069 Dresden (DE)
(72) Erfinder: Leo, Karl, 01219 Dresden (DE); Hummert, Markus, 01309 Dresden (DE); Falkenberg, Christiane, 01187 Dresden (DE); Hermenau, Martin, 01744 Dippoldiswalde (DE); Riede, Moritz, Dr., 01099 Dresden (DE); Olthof, Selina, 70619 Stuttgart (DE)
(74) Vertreter: Kailuweit & Uhlemann Patentanwälte Partnerschaft mbB

(56) Entgegenhaltungen:
- US-A1- 2007 116 895
- US-A1- 2009 301 552
- US-A1- 2010 006 154

## Beschreibung

Die vorliegende Erfindung betrifft eine organische Solarzelle nach den Merkmalen des Anspruchs 1.

Seit der Demonstration der ersten organischen Solarzelle mit einem Wirkungsgrad im Prozentbereich durch Tang et al. 1986 (C. W. Tang et al., Appl. Phys. Lett. 48, 183,1986) werden organische Materialien intensiv für verschiedene elektronische und optoelektronische Bauelemente verwendet. Organische Solarzellen bestehen aus einer Folge dünner Schichten, die typischerweise eine Dicke zwischen 1 nm bis 1 µm aufweisen. Ermöglicht wird dies durch die sehr hohen optischen Absorptionskoeffizienten organischer Absorbermaterialen von bis zu 10⁵ cm⁻¹. Die organischen Materialien werden bevorzugt im Vakuum aufgedampft oder aus Lösung aufgebracht. Die elektrische Kontaktierung erfolgt in der Regel durch transparente, semitransparente oder nicht transparente Metallschichten und / oder transparente leitfähige Oxide (TCOs) und / oder leitfähige Polymere. Der Vorteil organischer Solarzellen gegenüber den konventionellen anorganischen Halbleitermaterialien, wie Silizium oder Galliumarsenid, ist der geringe Material- und Energiebedarf und die Möglichkeit großflächige flexible Bauteile auf Basis von Plastik- oder Metallfolien herzustellen. Die Verwendung organischer Moleküle eröffnet durch die Variationsmöglichkeiten der organischen Chemie die Möglichkeit Materialien mit maßgeschneiderten Eigenschaften einzusetzen organische Solarzellen stellen daher bei der Herstellung von kostengünstigen Solarmodulen eine Schlüsseltechnologie dar.

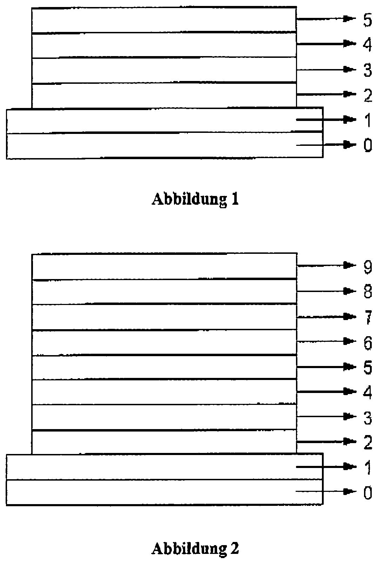

Eine in der Vergangenheit bereits vorgeschlagene Realisierungsmöglichkeit einer organischen Solarzelle besteht in einer p-i-n Diode (K. Walzer et al., Chem. Rev. 107, 1233, 2007), bzw. mehreren übereinander gestapelten p-i-n Dioden (B. Männig et al., Appl. Phys. A 79, 2004) mit folgendem Schichtaufbau gemäß Abbildung 1, beziehungsweise (Bsp. einer Tandemsolarzelle) gemäß Abbildung 2. Die Anordnung der organischen Schichten gemäß des p-i-n Konzepts zwischen den Elektroden ist nicht beschränkt auf obige Beispiele, sondern kann unter anderem auch mit Schichtstapeln der Geometrie n-i-p, p-n-i-p, p-n-i-p-n, n-i-p-n-i-p etc. umgesetzt werden. Hierbei bedeuten n bzw. p eine n- bzw. p-Dotierung der jeweiligen Schicht, die zu einer Erhöhung der Dichte freier Ladungsträger im thermischen Gleichgewichtszustand führt. In diesem Sinne sind derartige Schichten primär als Ladungsträgertransportschichten zu verstehen. Aus US5093698 und DE000010347856B4 ist die Dotierung organischer Materialien bekannt: Durch Beimischung einer akzeptorartigen bzw. donatorartigen Dotiersubstanz zu organischen Matrixmaterialien wird die Gleichgewichts-Ladungsträgerkonzentration in der Schicht erhöht und die Leitfähigkeit gesteigert. Nach US5093698 werden die dotierten Schichten als Injektionsschichten an der Grenzfläche zu den Kontaktmaterialien in elektrolumineszierenden Bauelementen verwendet. Ähnliche Dotierungsansätze sind analog auch für Solarzellen zweckmäßig. Für p- und n-Dotierung steht eine Auswahl an organischen Dotanden zur Verfügung: TCNQ (M. Maitrot et al., J. Appl. Phys. 60, 2396, 1986), F₄-TCNQ (M. Pfeiffer et al., Appl. Phys. Lett. 73, 3202, 1998), F₆-TNAP (P. K. Koech et al., Chem. Mater. 22, 3936, 2010), BEDT-TTF (A. Nollau et al., J. Appl. Phys. 87,4340, 2000), kationische Farbstoffe (A. Werner et al., Appl. Phys. Lett. 82, 4495, 2003; F. Li et al., J. Phys. Chem. B 108, 17076, 2004; F. Li et al., J. Appl. Phys. 100,023716,2006). Daneben können anorganische Dotanden wie WO₃ (C. C. Chang et al., Appl. Phys. Lett. 89 (25), 253504, 2006), MoO₃ (M. Kroger et al., Org. Electron. 10 (5), 932, 2009), Alkalimetalle (J. Kido et al., Appl. Phys. Lett. 73 (20), 2866, 1998) oder Metallkomplexdotanden wie Ru⁰(terpy)₃ (K. Harada et al., Phys. Rev. Lett. 94 (3), 036601, 2003) oder W₂(hpp₄) (WO002010057471A1) verwendet werden. Organischen Dotanden oder Metallkomplexdotanden sind im Allgemeinen der Verwendung von anorganischen Dotanden wie Lithium oder Cäsium (n-Dotierung) vorzuziehen, da diese oft aufgrund ihrer geringen Größe leicht im Bauelement diffundieren können und somit zum Einen die Herstellung definiert scharfer Übergänge zwischen unterschiedlich dotierten Gebieten erschweren oder die thermische Stabilität des Bauelements herabsetzen.

Eine oder mehrere i-Schicht(en) können hierbei sowohl aus nacheinander abgeschiedenen Schichten als auch so genannten interpenetrierend Netzwerken mehrerer Materialien bestehen. Das durch den transparenten Kontakt einfallende Licht erzeugt in der i-Schicht bzw. in der n-/p-Schicht zunächst Exzitonen, also elektrisch neutrale Anregungszustände (gebundene Elektron-Loch-Paare). Diese Exzitonen können nur durch sehr hohe elektrische Felder oder an geeigneten Grenzflächen getrennt werden. In organischen Solarzellen stehen ausreichend hohe Felder nicht zur Verfügung, so dass alle Erfolg versprechenden Konzepte für organische Solarzellen auf der Exzitonentrennung an den photoaktiven Grenzflächen beruhen (organische Donator-Akzeptor-Grenzfläche - C.W. Tang, Appl. Phys. Lett., 48 (2), 183, 1986) oder an der Grenzfläche von einem organischen zu einem anorganischen Halbleiter stattfinden (vgl. B. O'Regan et al., Nature 353, 737, 1991). Dafür ist es erforderlich, dass Exzitonen, die im Volumen des organischen Absorbermaterials generiert wurden, an diese photoaktive Grenzfläche diffundieren. Im eingebauten elektrischen Feld der Solarzelle werden die Elektronen nun zum n-Gebiet und die Löcher zum p-Gebiet abtransportiert.

Der Abtransport der Elektronen und der Löcher erfolgt dabei getrennt in der jeweiligen Schicht. Bezüglich des Ladungsträgertransports ist die Verwendung von Ladungsträgertransportmaterialien mit erhöhter Bandlücke (wide-gap Schichten) von Vorteil, die die Licht absorbierenden Bereiche der Solarzelle von den Kontaktelektroden bzw. der Rekombinationszone räumlich trennen und in denen weder Exzitonen noch Minoritätsladungsträger existieren, die rekombinieren könnten. Weiterhin dienen sie zum Schutz der i-Schicht(en) vor destruktiven Einflüssen während und nach der Abscheidung von Kontaktschichten bzw. Rekombinationszonen. Besonders vorteilhaft ist es, wenn sie nur im UV- bzw. UV-nahen Bereich des sichtbaren Sonnenspektrums absorbieren. Somit wird sichergestellt, dass die wesentliche Absorption in den aktiven i-Schichten stattfindet und keine Exzitonen in Bereichen generiert werden, die weiter als die Exzitonendiffusionslänge von der trennenden Grenzfläche entfernt sind. Eine parasitäre Absorption von sichtbarem Licht in den nichtstromerzeugenden Gebieten der Solarzelle wird hiermit verhindert. Zudem wird erreicht, dass Exzitonen an den Übergängen zu den wide-gap Schichten reflektiert und nicht dem photoaktiven Prozess entzogen werden, indem sie statt zum trennenden Interface in Richtung der Kontaktschichten bzw. der Rekombinationszone diffundieren, Die Transporteigenschaften in den wide-gap p- bzw. n-Schichten für Majoritätslandungsträger sind durch entsprechende p- bzw. n-Dotierung gegenüber undotierten Schichten entscheidend verbessert, so dass die Schichtdicken in einem weiten Bereich variiert werden können, um das Maximum des optischen Feldes auf die aktiven i-Schichten zu konzentrieren und somit zu optimieren (B. Männig, et al., Appl. Phys. A: Mater. Sci. Process. 79, 1, 2004). Die Anforderung nach Maximierung der eingebauten Spannung in den einzelnen Diodenstrukturen wird ebenfalls durch n- bzw. p-Dotierung der wide-gap Schichten erreicht Weiterhin können Solarzellen Tandem-, Tripel- oder allgemein Mehrfachzellen darstellen, die aus einem Stapel mehrerer Subzellen bestehen, wobei eine einzelne Zelle jeweils nur einen bestimmten Teil des Spektrums absorbiert, insgesamt aber ein breiter Spektralbereich absorbieren kann (T. Ameri et al., Energ. Environ. Sei. 2, 347, 2009). Dadurch können deutlich höhere Effizienzen als bei Einzelzellen erreicht werden. Der Einsatz von wide-gap Materialien als transparente Zwischenschichten zwischen den gestapelten Solarzellen, dient dazu die Dünnschichtoptik im Schichtstapel dahingehend zu optimieren, dass die Intensitätsmaxima des optischen Feldes jeweils in den Absorberschichten liegen. Dabei bleiben die elektrischen Eigenschaften des Bauelements aufgrund der herausragenden Leitfähigkeit der dotierten Transportmaterialien unbeeinflusst.

Um die oben beschriebenen Vorteile von wide-gap Transportschichten für die Herstellung effizienter photoaktiver Bauelemente vollständig auszunutzen, müssen die betreffenden Matrixmaterialien insbesondere eine Reihe von im Folgenden aufgeführten Kriterien erfüllen:
(1) Die betreffenden Transportmaterialien sollten nur im UV- bzw. UV-nahen Bereich des sichtbaren Sonnenspektrums absorbieren, das heißt die optische Bandlücke beträgt vorzugsweise 3 eV oder mehr. Damit ergibt sich näherungsweise ein Unterschied der Energieniveaus des HOMO (höchste besetzte Molekülorbital) und des LUMO (niedrigste unbesetzte Molekülorbital) von 3 eV oder mehr. Hiermit wird eine Transparenz der Transportschicht im sichtbaren Spektralbereich gewährleistet, welche eine parasitäre Absorption verhindert.
(2) Es muss eine Anpassung der Transportniveaus der Majoritätsladungsträger auf dem Akzeptor bzw. dem Donator der aktiven Schicht an die jeweilige angrenzende Ladungsträgertransportschicht gegeben sein. Insbesondere ist der Unterschied zwischen der HOMO Energie des Donators und der HOMO Energie des, unter Umständen p-dotierten, Löchertransportmaterials 0,3 eV oder kleiner, vorzugsweise aber 0 eV, sowie der Unterschied zwischen der LUMO Energie des Akzeptors und der LUMO Energie der (unter Umständen n-dotierten) Elektronentransportschicht 0,3 eV oder kleiner, vorzugsweise aber 0 eV. Demzufolge erfolgt der Übergang der Majoritätsladungsträger zwischen den betreffenden aktiven und transportierenden Schichten nahezu barrierefrei.
(3) Es sollte eine energetische Barriere zwischen dem LUMO Niveau des Donators und dem LUMO Niveau der (unter Umständen p-dotierten) Löchertransportschicht bzw. zwischen dem HOMO Niveau des Akzeptors und dem HOMO Niveau der (unter Umständen n-dotierten) Elektronentransportschicht existieren. Eine Diffusion der in den absorbierenden (aktiven) Schichten generierten Exzitonen in die angrenzenden Transportschichten muss durch diese Barrieren verhindert werden, da die Exzitonen hier bzw. an der Kontaktschicht mit erhöhter Wahrscheinlichkeit rekombinieren und somit für die Stromerzeugung verloren gehen-Stattdessen werden die Exzitonen an der genannten Grenzschicht in Richtung der aktiven Grenzschicht reflektiert. Eine solche Barriere ergibt sich beispielsweise als Konsequenz aus den genannten Punkten (1) und (2), sofern der oder die Absorber eine kleinere optische Bandlücke haben, als das wide-gap Transportmaterial.
(4) Weiterhin sollte die Lage der Energieniveaus eine effiziente Dotierung des jeweiligen Ladungsträgertransportmaterials mit molekularen Dotanden erlauben. Hiermit wird eine signifikante Erhöhung der Leitfähigkeit für Elektronen bzw. Löcher erreicht, die die in der jeweiligen Transportschicht auftretenden Ohmschen Verluste minimiert. Die erreichte Leitfähigkeit sollte vorzugsweise im Bereich von 10⁻⁴ S cm⁻¹ oder größer liegen, mindestens aber 10⁻⁶ S cm⁻¹ betragen.
(5) Die Transportschichten sollten eine möglichst hohe intrinsische Ladungsträgerbeweglichkeit für die jeweiligen Majoritätsladungsträger aufweisen, um die Wahrscheinlichkeit einer Rekombination der Ladungsträger auf dem Weg zur Elektrode zu minimeren. Die entsprechenden Beweglichkeiten sollten im Bereich von 10⁻² cm² (Vs)⁻¹ oder höher liegen, mindestens aber in der Größenordnung der in der angrenzenden (aktiven) Schicht erreichten Beweglichkeit.
(6) Die betreffenden Transportschichten sollten geschlossene, glatte Schichten mit möglichst geringer mittlerer quadratischer Oberflächenrauigkeit bilden, um ein glattes Wachstum aller nachfolgenden Schichten zu gewährleisten. Insbesondere ist amorphes Wachstum vorteilhaft, da dieses die Diffusion von Dotanden oder Metallatomen der Kontaktelektroden entlang von andernfalls evtl. existierenden Korngrenzen ausschließt.
(7) Die als Transportschichten verwendeten Materialien müssen thermisch und morphologisch stabil sein, damit sie sich weder beim Aufdampfen noch beim Betrieb in der fertigen Solarzelle zersetzen bzw. ihre Struktur oder sonstige Eigenschaften ändern.
(8) Die Reduktionspotentiale bzw. Oxidationspotentiale des Materials müssen reversibel sein, damit das Molekül nach Übertragung eines Ladungsträgers wieder uneingeschränkt für weitere Transportprozesse zur Verfügung stehen kann.
(9) Das in den Transportschichten verwendete Elektronentransportmaterial (ETM) sollte einfach zu synthetisieren sein, um auch ökonomisch sinnvoll eingesetzt werden zu können.

Insbesondere soll das ETM die oben genannten Forderungen in hinreichendem Umfang erfüllen, um in der Folge das p-i-n Konzept für organische Solarzellen in vollständiger Konsequenz umsetzbar zu machen. Dabei soll neben der Einsetzbarkeit in p-i-n Strukturen insbesondere auch eine Umsetzbarkeit von n-i-p, m-i-n und Tandem-, Tripel- bzw. Mehrfachzellenstrukturen durch eben dieses ETM möglich werden.

Auf Seiten der Löchertransportmaterialien gibt es bereits eine beachtliche Anzahl an Substanzen, die sich gemessen an den geforderten Eigenschaften sehr gut für den Einsatz in organischen photoaktiven Bauelementen, die gemäß des p-i-n Konzepts aufgebaut sind, eignen. Genannt seien hier beispielsweise PV-TPD (N,N'-(4-(2,2-diphenyl-ethen-1-yl)-phenyl)-N,N'-di(4-methylphenylphenyl)benzidin) oder Di-NPB (N,N'-diphenyl-N,N'-bis(4-[N,N'-bis(naphth-1-yl)-amino]-biphenyl-4-yl)-benzidine), deren Eigenschaften vergleichend in der Arbeit "Characterisation of different hole transport materials as used in organic p-i-n solar cells" (S. Pfützner et al., Proc. of SPIE 6999, 69991M, 2008) dargestellt sind. Hingegen sind hinsichtlich der genannten Anforderungen bisher kaum geeignete Elektronentransportmaterialien bekannt. Im Rahmen des p-in Konzepts wurden aus Mangel an Alternativen bis dato nur die Materialien C₆₀, 1,4,5,8-Naphtalintetracarboxydianhydrid (NTCDA) und Hexaazatriphenylen-hexacarbonitril (HATCN) als n-dotierbare ETM eingesetzt, welche jeweils einen Teil der geforderten Eigenschaften nicht erfüllen können. Das Fulleren C₆₀ ist ein im sichtbaren Bereich des Spektrums absorbierendes Material und wird daher gewöhnlicher weise eher als Akzeptor in der aktiven Schicht, denn als Transportmaterial eingesetzt. Die Verwendung desselben Materials in beiden Funktionen bedingt zwar eine gute Anpassung der LUMO Niveaus und somit einen barrierefreien Transport der Elektronen (Punkt (2)), bedeutet aber gleichzeitig das Fehlen einer Barriere für die Exzitonendiffusion in Richtung des Kontaktes (Punkt (3)) sowie eine parasitäre Absorption des eingestrahlten Lichtes in der dotierten Schicht (Punkt (1)). Im Gegensatz zu C₆₀ erfüllt das Material NTCDA die Forderungen (1) bis (3) hinsichtlich der energetischen Eigenschaften: Es ist transparent mit einer optischen Energielücke von 3,05 eV, während das LUMO mit ca. 4,0 eV auf der Höhe des C₆₀ LUMOs liegt (C. Falkenberg et al., J. Appl. Phys. 104, 034506, 2008 und C. K. Chan et al., Adv. Funct. Mater. 16, 831, 2006). Der entscheidende Nachteil von NTCDA ist seine niedrige Glasübergangstemperatur, woraus ein sehr kristallines Wachstum mit mittleren quadratischen Oberflächenrauigkeiten von bis zu 22 nm beim Aufdampfen auf Raumtemperatur-Substrate resultiert (C. Falkenberg et al., Proc. SPIE 6999, 69990S, 2008). Schichten, die dünner als 40 nm sind, sind nicht geschlossen. Daher resultieren alle Versuche NTCDA in einer Struktur einzusetzen, in der es nicht die oberste organische Schicht unter dem Deckkontakt bildet (bspw. n-i-p) in kurzgeschlossenen Bauelementen. Insbesondere wird durch die überaus hohe Rauigkeit der Einsatz des Materials als transparente Zwischenschicht, dem sogenannten Spacer, in Tandem- oder Tripelsolarzellen verhindert. Das Material HATCN hat eine ungewöhnlich hohe Elektronenaffinität, wodurch eine Anpassung des Elektronentransportniveaus zum Donator C₆₀ nicht gewährleistet werden kann (Punkt (2)), Es ergibt sich eine Injektionsbarriere für Elektronen, die die Funktion der entsprechenden p-i-n Solarzelle erheblich beeinträchtigt und welche nur durch das Einfügen zusätzlicher Schichten, also durch zusätzliche Prozessschritte, entfernt werden kann (C. Falkenberg et al., Sol. Energ, Mat. Sol. C. 95, 927, 2011). Aus Mangel eines geeigneten ETM wird die sogenannte p-i-i Struktur der p-i-n Struktur vorgezogen wird- Die n-dotierte Elektronentransportschicht wird hier durch eine undotierte Pufferschicht ersetzt, welche die aktiven intrinsischen Schichten vor den heißen Metallatomen des Deckkontakts schützt. Gewöhnlich werden zu diesem Zweck die transparenten Materialien BPhen (Bathophenanthrolin) oder BCP (Bathocuproin) eingesetzt, die jedoch aufgrund ihrer relativ geringen Elektronenaffinität nicht oder nur bedingt n-dotierbar sind. Aufgrund der geringen Elektronenleitfähigkeit bzw. - beweglichkeit dieser Schichten können diese nur mit geringen Schichtdicken von < 15 nm eingesetzt werden, da sie sonst die Injektion der Elektronen behindern (M. Y. Chan et al., J. Appl. Phys. 100, 094506, 2006; P. Peumans et al., J. Appl. Phys. 93, 3693, 2003). Dies ist ein entscheidender Nachteil gegenüber eines transparenten n-dotierbaren ETM, dessen Schichtdicke aufgrund der guten Leitfähigkeiten nahezu frei wählbar ist Insbesondere für Tandem oder Mehrfachsolarzellen ist die Verwendung eines transparenten n-dotierten Elektronentransport-materials als sogenannter optischer Spacer und / oder als Teil eines effizienten p/n Ladungsträger-Konversionskontaktes zwischen den Subzellen interessant. Aus Mangel an geeigneten transparenten n-dotierbaren ETM wird der optische Spacer in der Regel von einem p-dotierten Löchertransportmaterial gebildet, während im Konversionskontakt n-C₆₀ eingesetzt wird, welches die bereits im Kontext der Einzelzellen genannten Nachteile besitzt (R. Schüppel, J. Appl. Phys. 107, 044503, 2010; R. Timmreck, J. Appl. Phys. 108,033108,2010).

### Aufgabe der Erfindung

Die Aufgabe der Erfindung besteht darin, eine organische Solarzelle mit verbessertem Elektronentransportmaterial bereitzustellen. Das Bauelement soll aufgrund der gegenüber des Standes der Technik verbesserten Eigenschaften des Elektronentransportmaterials eine gesteigerte Lichtabsorption und damit verbunden eine erhöhte Effizienz zeigen.

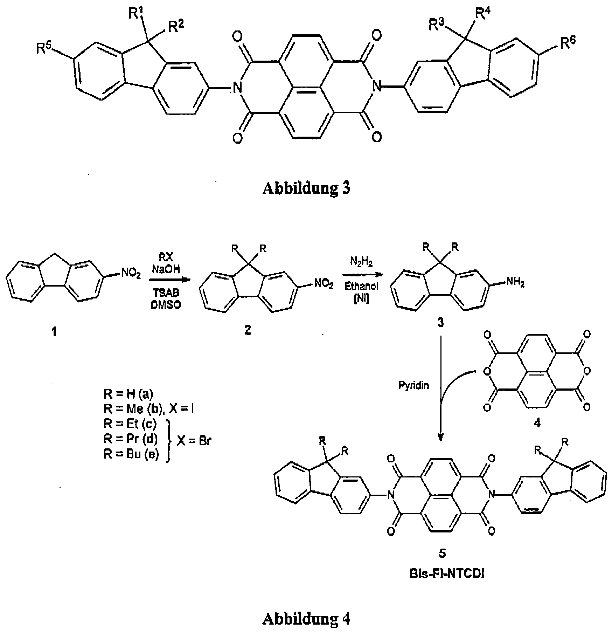

Erfindungsgemäß wird diese Aufgabe gelöst durch 2,7-Bis(9*H*-fluoren-2-yl)benzo[lmn][3,8]phenanthrolin-1,3,6,8(2H,7H)tetron-Verbindungen (5), hier N,N-Bis(fluoren-2-yl)-naphthalintetracarboxydiimid (Bis-F1-NTCDI) genannt, der allgemeinen Formel (Abbildung 3), wobei die Reste (R) Atome oder Atomgruppen repräsentieren.

Bevorzugt sind N,N-Bis(fluoren-2-yl)-naphthalintetracarboxydiimid Verbindungen vorgesehen, wobei R¹-R⁶ unabhängig ausgewählt ist aus Wasserstoff, Halogen, unsubstituiertem oder substituiertem, gesättigtem oder ungesättigtem C₁-C₂₀-Alkyl, C₁-C₂₀-Heteroalkyl, C₁-C₂₀-Alkenyl, C₁-C₂₀-Heteroalkenyl, C₁-C₂₀Alkinyl, C₁-C₂₀-Heteroalkinyl, C₆-C₂₀-Aryl, C₆-C₂₀-Heteroaryl, gesättigtem oder ungesättigtem Carbo- oder Heterocyclus, die gleich oder verschieden sein können, wobei zwei benachbarte Reste R¹-R⁶ auch Bestandteil eines weiteren gesättigten oder ungesättigten, carbocyclischen oder heterocyclischen Rings sein können, wobei der Ring C, N, O, S, Si und Se umfassen kann. Besonders bevorzugt sind N,N-Bis(fluoren-2-yl)-naphthalintetracarboxydimid Verbindungen wobei R¹-R⁶ unabhängig ausgewählt ist aus Wasserstoff, Halogen, unsubstituiertem oder substituiertem, gesättigtem oder ungesättigtem C₁-C₃-Alkyl, C₁-C₃-Heteroalkyl, C₁-C₃-Alkenyl, C₁-C₃-Heteroalkenyl, C₁-C₃-Alkinyl, C₁-C₃-Heteroalkinyl, die gleich oder verschieden sein können, wobei zwei benachbarte Reste R¹-R⁶ auch Bestandteil eines weiteren gesättigten oder ungesättigten, carbocyclischen oder heterocyclischen Rings sein können, wobei der Ring C, N, O, S, Si und Se umfassen kann. Am bevorzugtesten sind N,N-Bis(fluoren-2-yl)-naphthalintetracarboxydimid Verbindungen wobei R¹-R⁶ unabhängig ausgewählt ist aus Wasserstoff, Halogen, C₁-C₂-Heteroalkinyl, die gleich oder verschieden sein können.

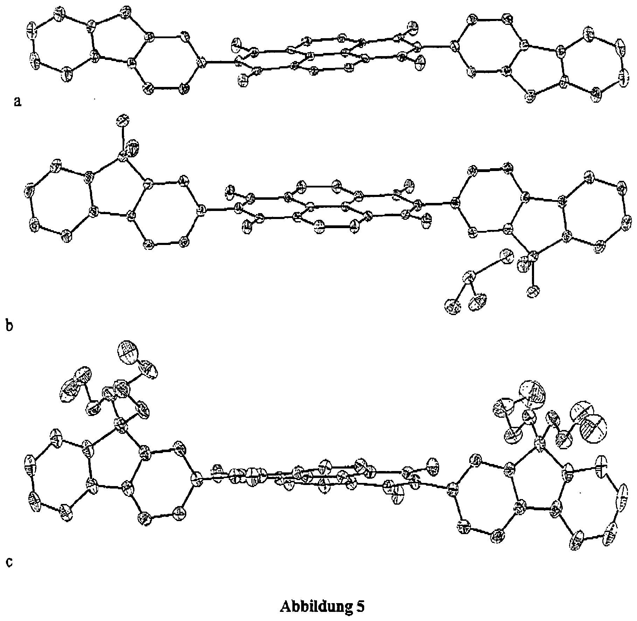

Die erfindungsgemäßen Bis-Fl-NTCDI-Verbindungen sind in der Literatur bislang noch nicht beschrieben worden. Generell finden sich in der Literatur für die Kondensation aromatischer Amine mit NTCDA einige Methoden unter Verwendung von hochsiedenden Lösungsmitteln (wie Dimethylformamid oder Diethylformamid), teilweise auch mit Zusätzen von Zinkacetat als Promoter. Die Kondensation der Fluoren-2-yl-amine zu den Bis-Fl-NTCDI-Verbindungen wurde in niedrig siedendem Pyridin als Lösungsmittel realisiert, was eine höhere Reinheit der Produkte mit sich bringt (Abbildung 4). Die für die Kondensation benötigten Amine wurden direkt von Chemikalienlieferanten bezogen oder in einer zweistufigen Synthese hergestellt. Darin wird 2-Nitrofluoren zuerst am verbrückenden C9-Kohlenstoffatom alkyliert und anschließend die Nitrofunktion durch Hydrierung in das entsprechende Fluoren-2-yl-amin überführt. Von den Bis-RF1-NTCDI-Verbindungen **5b** (R = Methyl, Me) und **5e** (R = Butyl, Bu) konnten Einkristalle gewonnen werden, die für eine Röntgenstrukturanalyse geeignet waren, Die Struktur der Bis-RF1-NTCDI-Verbindungen (R = H, Me und Bu) konnte aus den Beugungsdaten bewiesen werden (Abbildung 5).

Erfindungsgemäß ist die Verwendung der Bis-Fl-NTCDI Verbindung in einer organischen Solarzelle als Exzitonenblocker und / oder Elektronentransportschicht oder als Konvertierungskontakt zu einer Elektrode innerhalb eines p/n-Übergangs in einer gestapelten organischen Solarzelle.

Die Aufgabe wird ebenfalls gelöst durch eine organische Verbindung, umfassend mindestens ein organisches Matrixmaterial, das mit mindestens einem Dotanden dotiert ist, wobei das Matrixmaterial eine erfindungsgemäße Bis-Fl-NTCDI Verbindung ist. Dabei ist die Bis-Fl-NTCDI Verbindung bevorzugt n-dotiert, wobei die Dotierungstechniken dem Fachmann bekannt sind.

Erfindungsgemäß ist ebenfalls ein p/n Übergang in einem organischen elektronischen Bauelement zur Verbindung von gestapelten organischen Solarzellen bzw. als Konvertierungskontakt zu einer Elektrode ("Highly doped layers as efficient electron-hole recombination contacts for tandem organic solar cells", R. Timmreck, J. Appl. Phys. 108, 033108, 2010 oder EP1804308).

Erfindungsgemäß ist auch ein p/n Übergang in einem organischen elektronischen Bauelement, der die Injektion von Ladungsträgern in Form von Löchern in eine Schicht aus einem organischen Halbleitermaterial vom p-Typ verbessert, wobei die Schicht aus dem organischen Halbleitermaterial vom n-Typ mit einer als Anode ausgeführten Elektrode in Kontakt ist.

Erfindungsgemäß ist auch ein p/n Übergang in einem organischen elektronischen Bauelement, wobei der Übergang auf der n-Seite eine Bis-Fl-NTCDI Verbindung in einer Elektronentransportschicht umfasst und / oder eine Bis-Fl-NTCDI Verbindung in einer Zwischenschicht zwischen der p- und der n-Seite umfasst.

Erfindungsgemäß ist auch ein p/n Übergang in einem organischen elektronischen Bauelement, wobei der Übergang auf der n-Seite eine Bis-Fl-NTCDI Verbindung in einer Elektronentransportschicht umfasst und / oder eine dünne Metallschicht in einer Zwischenschicht zwischen der p- und der n-Seite umfasst.

Es ist bekannt, dass ein solcher p/n Übergang sehr effizient funktioniert, wenn beide Materialien von p- und n-Typ dotiert sind (EP1804308, EP1804309).

Es wurde festgestellt, dass die erfindungsgemäßen Bis-Fl-NTCDI Verbindungen als Elektronentransportmaterialien eingesetzt werden können. Durch bevorzugte Dotierung mit Metallkomplexen wie beispielsweise W₂(hpp)₄ und auch mit kationischen Farbstoffen (Acridine Orange Base) kann eine signifikant verbesserte Leitfähigkeit erreicht werden. Die verbesserte Elektronentransportschicht ist aufgrund einer optischen Bandlücke von > 3 eV ist im sichtbaren Bereich des Sonnenspektrums vollständig transparent. Die erfingdungsgemäß vorgeschlagenen Bis-Fl-NTCDI Verbindungen haben beim Einsatz als Elektronentransportmaterialien in organischen photovoltaischen Bauelementen das Potential eine gegenüber dem Stand der Technik erhöhte Photostromdichte und damit eine erhöhte Leistungseffizienz zu erreichen. Weiterhin konnte eine erhöhte Langzeitstabilität nachgewiesen werden.

Die Erfindung wird nachfolgend an Hand von Ausführungsbeispielen näher beschrieben. Es zeigen:
Abbildung 1: Organische Solarzelle nach dem Prinzip einer Einzeldiodenstruktur ("p-i-n bzw. n-i-p Solarzelle") mit Substrat (0), Grundelektrode (1), Löchertransportschicht(en) oder Elektronentransportschicht(en) (2), photoaktiven Absorberschichten (3), Elektronentransportschicht(en) oder Löchertransportschicht(en) (4) und Abschlusselektrode (5).
Abbildung 2: Organische Mehrfachsolarzelle nach dem Stapelprinzip ("p-i-n-p-i-n bzw. n-i-p-n-i-p Tandemsolarzelle") mit Substrat (0), Grundelektrode (1), Löchertransportschicht(en) oder Elektronentransportschicht(en) (2), photoaktiven Absorberschichten (3), Elektronentransportschicht(en) oder Löchertransportschicht(en) (4) Rekombinationskontakt (5), Löchertransportschicht(en) oder Elektronentransportschicht(en) (6), photoaktiven Absorberschichten (7), Elektronentransportschicht(en) oder Löchertransportschicht(en) (8) und Abschlusselektrode (9).
Abbildung 3: Allgemeine Strukturformel von N,N-Bis(fluoren-2-yl)-naphthalintetracarboxydiimid (Bis-Fl-NTCDI.).
Abbildung 4: Syntheseschema für die Herstellung der erfindungsgemäßen Bis-Fl-NTCDI-Verbindungen.
Abbildung 5: ORTEP-Darstellung der Molekülstrukturen von Bis-HFl-NTCDI (a, **5a**), Bis-MeFl-NTCDI (b, **5b** CHCl₃) und Bis-BuFl-NTCDI (c, **5e**) aus Einkristall-Röntgenstrukturanalysen.
Abbildung 6: Optische Dichte eines 65 nm dicken Bis-HFl-NTCDI (**5a**) Dünnfilms auf Glas.
Abbildung 7: AFM-Mikroskopische Oberflächenanalyse eines Dünnfilms aus Bis-HFl-NTCDI (**5a**) auf Glas.
Abbildung 8: Cyclovoltammogramm mit den beiden Peaks der ersten beiden Halbstufenpotentialen (Reduktion) der Verbindung Bis-BuFl-NTCDI (**5e**).
Abbildung 9: UPS Spektrum eines 20 nm dicken Bis-HFl-NTCDI (**5a**) Dünnfilms auf einem Silbersubstrat. Besonders gekennzeichnet sind die Sekundärelektronen-Emissionskante und die Valenzelektronen-Emissionskante.
Abbildung 10: Entwicklung des Querstroms einer mit 7% W₂(hpp)₄ n-dotierten Bis-HFl-NTCDI-Schicht (**5a**) während des Wachstums der Schicht durch thermische Ko-Verdampfung im Hochvakuum, sowie Struktur von W₂(hpp)₄.
Abbildung 11: Schichtaufbau der Vergleichssolarzellen und Strukturen verwendeter Materialien.
Abbildung 12: Strom-Spannungs-Kennlinien der Solarzelle mit Bis-HFl-NTCDI (**5a**) in der Elektronentransportschicht und der Vergleichssolarzelle mit dem Standardelektronentransportsystem n-C₆₀.
Abbildung 13: Externe Quanteneffizienz der Solarzelle mit Bis-HFl-NTCDI (**5a**) in der Elektronentransportschicht und der Vergleichssolarzellen mit dem Standardelektronentransport-system n-C₆₀.
Abbildung 14: Schichtaufbau der gealterten Solarzelle und Strukturen verwendeter Materialien.
Abbildung 15: Zeitlicher Verlauf der Effizienz einer Bis-HFl-NTCDI (**5a**) enthaltenden organischen p-i-n Solarzelle unter einer Bestrahlung von 112 mW cm⁻².

### Ausführungsbeispiele

### Synthesebeispiele für Bis-RFl-NTCDI-Verbindungen:

**9,9-Dimethyl-2-nitro-9*H*-fluoren (2b):** Eine wässrige Natriumhydroxid-Lösung (10,8 mL, 50 %) wurde unter Wasserbadkühlung zu einer Lösung von 2-Nitro-9*H*-fluoren (**1**, 5,25 g, 24,86 mmol) und Tetrabutylammoniumbromid (0,40 g, 1,24 mmol) in DMSO (100 mL) und Iodmethan (7,9 mL, 126 mmol) gegeben. Die Reaktionsmischung wurde für 30 min gerührt und in 0,8 L Wasser gegossen. Das Gemisch wurde mehrfach mit Dichlormethan extrahiert, die vereinigten organischen Phasen über wasserfreiem Natriumsulfat getrocknet und eingeengt Der Rückstand wurde mit Cyclohexan von einer 3 cm dicken Schicht Kieselgel K60 extrahiert. Nach Entfernen des Lösungsmittels des Extraktes wurden 5,06 g (**2b**, 21,15 mmol, 85 %) des Produktes als leicht gelblicher Feststoff erhalten,

Smp.103 °C. C₁₅H₁₃NO₂ (239,27 g mol⁻¹): Ber. (%) C 75,30, H 5,48, N 5,85; Gef. C 75,56, H 5,29, N 5,95. IR(ATR): ν = 3064 (w), 2967 (m), 2926 (w), 2883 (w), 1611 (w), 1589 (m), 1558 (m), 1541 (m), 1511 (s), 1469 (m), 1440 (w), 1358 (w), 1330 (s), 1309 (s), 1218 (w), 1157 (w), 1127 (m), 1109 (m), 1061 (m), 1027 (w), 940 (w), 887 (m), 829 (m), 799 (m), 769 (w), 30 (s), 652 (w), 573 (m). ¹H NMR (CDCl₃, 500 MHz): *δ* = 8,29 (s, 1 H, Hₐᵣ), 8,25 (d, ³*J*_{HH} = 8,3 Hz, 1 H, Hₐᵣ), 7,79-7,81 (m, 2 H, Hₐᵣ), 7,49 (d, ³*J*_{HH} = 6,9 Hz, 1 H, Hₐᵣ), 7,39-7,45 (m, 2 H, Hₐᵣ), 1,53 (s, 6 H, CH₃) ppm. ¹³C NMR (CDCl₃, 126 MHz): *δ* = 155,0 (C), 154,6 (C), 147,2 (C), 145,7 (C), 136,8 (C), 129,4 (CH), 127,6 (CH), 123,4 (CH), 123,0 (CH), 121,4 (CH), 120,1 (CH), 118,3 (CH), 47,3 (9-C), 26,7 (CH₃) ppm. ESI-MS (+25 V, MeOH, 0,1 % NH₄OAC): *m*/*z* 240,1 [M + H]⁺.

**9,9-Diethyl-2-nitro-9*H*-fluoren (2c):** Eine wässrige Natriumhydroxid-Lösung (16,7 mL, 50 %) wurde unter Wasserbadkühlung zu einer Lösung von 2-Nitro-9*H*-fluoren (1, 8,45 g, 40 mmol) und Tetrabutylammoniumbromid (0,64 g, 2 mmol) in DMSO (200 mL) und Bromethan (15 mL, 200 mmol) gegeben. Die Reaktionsmischung wurde für 30 min gerührt und in 1,5 L Wasser gegossen. Das Gemisch wurde mehrfach mit Dichlormethan extrahiert, die vereinigten organischen Phasen über wasserfreiem Natriumsulfat getrocknet und eingeengt. Der Rückstand wurde mit Cyclohexan von einer 3 cm dicken Schicht Kieselgel K60 extrahiert. Nach Entfernen des Lösungsmittels des Extraktes wurden 8,65 g (32,36 mmol, 81 %) des Produktes **2c** als leicht gelblicher Feststoff erhalten.

Smp. 121 °C. C₁₇H₁₇NO₂ (267,32 g mol⁻¹): Ber. (%) C 76,38, H 6,41, N 5,24; Gef. C 76,41, H 6,54, N 5,37. IR(ATR): ν = 3062 (w), 2960 (m), 2922 (m), 2854 (w), 1608 (w), 1589 (m), 1517 (m), 1465 (m), 1447 (m), 1396 (w), 1330 (s), 1264 (w), 1190 (w), 1128 (m), 1069 (m), 1038 (w), 900 (m), 839 (m), 771 (m), 754 (s), 736 (s), 650 (m), 601 (m), 559 (m). ¹H NMR (CDCl₃, 500 MHz): *δ* = 8,26 (d, ³*J*_{HH} = 8,2 Hz, 1 H, Hₐᵣ), 8,19 (s, 1 H, Hₐᵣ), 7,78-7,80 (m, 2 H, Hₐᵣ), 7,34-7,44 (m, 3 H, Hₐᵣ), 2,04-2,15 (m, 4 H, CH₂), 0,30 (t, ³*J*_{HH} = 7,4 Hz, 6 H, CH₃) ppm. ¹³C NMR (CDCl₃, 126 MHz): *δ* = 151,4 (C), 151,1 (C), 148,0 (C), 147,1 (C), 139,1 (C), 129,2 (CH), 127,4 (CH), 123,3 (CH), 123,2 (CH), 121,1 (CH), 119,7 (CH), 118,3 (CH), 56,7 (9-C), 32,5 (CH₂), 8,4 (CH₃) ppm. ESI-MS (+10 V, MeOH, 0,1 % NH₄OAc): *m*/*z* 268,1 [M + H]⁺.

**2-Nitro-9,9-dipropyl-9*H*-fluoren (2d):** Eine wässrige Natriumhydroxid-Lösung (13,0 mL, 50 %) wurde unter Wasserbadkühlung zu einer Lösung von 2-Nitro-9*H*-fluoren (1, 6,34 g, 30 mmol) und Tetrabutylammoniumbromid (0,40 g, 1,24 mmol) in DMSO (100 mL) und 1-Brompropan (13,6 mL, 149 mmol) gegeben. Die Reaktionsmischung wurde für 30 min gerührt und in 1 L Wasser gegossen. Das Gemisch wurde mehrfach mit Dichlormethan extrahiert, die vereinigten organischen Phasen über wasserfreiem Natriumsulfat getrocknet und eingeengt Der Rückstand wurde mit Cyclohexan von einer 3 cm dicken Schicht Kieselgel K60 extrahiert. Nach Entfernen des Lösungsmittels des Extraktes wurden 7,85 g (26,58 mmol, 89 %) des Produktes **2d** als leicht gelblicher Feststoff erhalten.

Smp. 106 °C. C₁₉H₂₁NO₂ (295.16 g mol⁻¹): Ber. (%) C 77,26, H 7,17, N 4,74; Gef. C 77,46, H 7,37, N 4,81. IR(ATR): ν = 30662 (w), 2958 (m), 2928 (m), 2873 (w), 2857 (w), 1609 (w), 1589 (m), 1559 (m), 1541 (w), 1515 (m), 1468 (m), 1398 (w), 1375 (w), 1333 (s), 1247 (w), 1157 (w), 1129 (m), 1078 (m), 1049 (w), 1026 (w), 904 (m), 876 (m), 836 (m), 769 (m), 736 (s), 638 (m), 589 (m), 558 (w). ¹H NMR (CDCl₃, 500 MHz): *δ* = 8,25 (d, ³*J*_{HH} = 8,4 Hz, 1 H, Hₐᵣ), 8,21 (s, 1 H, Hₐᵣ), 7,76-7,78 (m, 2 H, Hₐᵣ), 7,37-7,43 (m, 3 H, Hₐᵣ), 1,97-2,06 (m, 4 H, CH₂), 0,58-0,68 (m, 10 H, CH₂/CH₃) ppm. ¹³C NMR (CDCl₃, 126 MHz): *δ* = 152,3 (C), 151,9 (C), 147,6 (C), 147,1 (C), 138,7 (C), 129,2 (CH), 127,4 (CH), 123,2 (CH), 123,2 (CH), 121,1 (CH), 119,7 (CH), 118,3 (CH), 55,8 (9-C), 42,3 (CH₂), 17,1 (CH₂), 14,3 (CH₃) ppm. ESI-MS (+25 V, MeOH, 0,1 % NH₄OAc): *mlz* 296,2 [M + H]⁺.

**9,9-Dibutyl-2-nitro-9*H-*fluoren (2e):** Eine wässrige Natriumhydroxid-Lösung (20,9 mL, 50 %) wurde unter Wasserbadkühlung zu einer Lösung von 2-Nitro-9*H-*fluoren (1, 10,55 g, 50 mmol) und Tetrabutylammoniumbromid (0,64 g, 2 mmol) in DMSO (200 mL) und Butylbromid (26,8 mL, 250 mmol) gegeben. Die Reaktionsmischung wurde für 30 min gerührt und in 1,8 L Wasser gegossen. Das Gemisch wurde mehrfach mit Dichlormethan extrahiert, die vereinigten organischen Phasen über wasserfreiem Natriumsulfat getrocknet und eingeengt. Der Rückstand wurde mit Cyclohexan von einer 3 cm dicken Schicht Kieselgel K60 extrahiert. Nach Entfernen des Lösungsmittels des Extraktes wurden 14,62 g (2e, 25,2 mmol, 90 %) des Produktes als leicht gelblicher Feststoff erhalten.

Smp. 75 °C. C₂₁H₂₅NO₂ (323.19 g mol⁻¹): Ber. (%) C 77,98, H 7,79, N 4,33; Gef. C 77,36, H 7,86, N 4,32. IR(ATR): ν = 3061 (w), 2956 (m), 2927 (m), 2855 (m), 1608 (m), 1590 (m), 1559 (w), 1514 (m), 1463 (m), 1397 (w), 1334 (s), 1304 (m), 1230 (w), 1158 (w), 1129 (m), 1077 (m), 1003 (w), 964 (w), 898 (m), 837 (m), 777 (m), 738 (s), 632 (m), 596 (m), 570 (w). ¹H NMR (CDCl₃, 500 MHz): *δ* = 8,26 (d, ³*J*_{HH} = 8,2 Hz, 1 H, Hₐᵣ), 8,21 (s, 1 H, Hₐᵣ), 7,78-7,80 (m, 2 H, Hₐᵣ), 7,38-7,44 (m, 3 H, Hₐᵣ), 1,99-2,08 (m, 4 H, CH₂), 1,04-1,11 (m, 4 H, CH₂), 0,65 (t, ³*J*_{HH} = 7,3 Hz, 6 H, CH₃), 0,52-0,59 (m, 4 H, CH₂) ppm. ¹³C NMR (CDCl₃, 126 MHz): *δ* = 152,2 (C), 151,9 (C), 147,6 (C), 147,1 (C), 138,7 (C), 129,2 (CH), 127,3 (CH), 123,0 (CH), 123,1 (CH), 121,1 (CH), 119,7 (CH), 118,2 (CH), 55,5 (9-C), 39,8 (CH₂), 25,8 (CH₂), 22,9 (CH₂), 13,7 (CH₃) ppm. ESI-MS (+25 V, MeOH, 0,1 % NH₄OAc): *m*/*z* 324,2 [M + H]⁺.

**9,9-Dimethyl-9*H*-fluoren-2-amin (3b):** 9,9-Dimethyl-2-nitro-9*H*-fluoren (**2b**, 3,82 g, 15,97 mmol) wurde in Ethanol (80 mL) gelöst und mit Hydrazin-Hydrat-Lösung (2,3 mL, 47,3 mmol) versetzt Nach Erwärmen auf 55-60 °C wurden kleine Portionen Raney-Nickel dazugegeben, bis sich die Lösung entfärbt und sämtliches Ausgangsprodukt verbraucht war, was durch eine Dünnschichtchromatographie verfolgt wurde (Hexane/Ethylacetat (9:1)). Danach wurde noch eine Stunde in der Siedehitze gerührt und der Katalysator heiß abfiltriert. Das Lösungsmittel wurde destillativ entfernt und der Rückstand mit Hexan umkristallisiert. Das Produkt **3b** wurde durch Filtration als weißes Pulver (3,15 g, 15,05 mmol, 94 %) erhalten.

Smp. 169 °C. C₁₅H₁₅N (209,29 g mol⁻¹): Ber. (%) C 86,08, H 7,22, N 6,69; Gef. C 86,30, H 7,40, N 6,76. IR(ATR): ν = 3485 (w), 3382 (m), 3200 (w), 3035 (w), 2955 (w), 2918 (w), 2858 (w), 1611 (s), 1581 (w), 1492 (w), 1444 (s), 1352 (m), 1310 (m), 1277 (w), 1227 (m), 1211 (m), 1134 (w), 1070 (w), 1018 (m), 940 (w), 865 (m), 821 (m), 777 (m), 756 (s), 733 (s), 697 (m), 623 (m), 598 (m), 570 (m), 555 (m). ¹H NMR (CDCl₃ 500 MHz): *δ* = 7,58 (d, ³*J*_{HH} = 7,5 Hz, 1 H, Hₐᵣ), 7,51 (d, ³*J*_{HH} = 8,0 Hz, 1 H, Hₐᵣ), 7,37 (d, ³*J*_{HH} = 7,5 Hz, 1 H, Hₐᵣ), 7,28 (dd, ³*J*_{HH} = 7,5 Hz, ³*J*_{HH} = 7,4 Hz, 1 H, Hₐᵣ), 7,21 (dd, ³*J*_{HH} = 7,5 Hz, ³*J*_{HH} = 7,4 Hz, 1 H, Hₐᵣ), 6,76 (s, 1 H, Hₐᵣ) 6,66 (d, ³*J*_{HH} = 8,0 Hz, 1 H, Hₐᵣ), 3,76 (br. s, 2 H, NH₂), 1,45 (s, 6 H, CH₃) ppm. ¹³C NMR (CDCl₃, 126 MHz): *δ* = 155,5 (C), 152,7 (C), 146,1 (C), 139,6 (C), 130,2 (C), 126,8 (CH), 125,5 (CH),122,3 (CH), 120,8 (CH), 118,6 (CH), 113,9 (CH), 109,5 (CH), 46,6 (9-C), 27,3 (CH₃) ppm. ESI-MS (+25 V, MeOH, 0,1 % NH₄OAc): *m*/*z* 210,1 [M + H]⁺.

**9,9-Diethyl-9*H*-fluoren-2-amin (3c):** 9,9-Diethyl-2-nitro-9*H*-fluoren **(2c)** (7,51 g, 28,09 mmol) wurde in Ethanol (100 mL) gelöst und mit Hydrazin-Hydrat-Lösung (5 mL, 80%, 82,3 mmol) versetzt. Nach Erwärmen auf 55-60 °C wurden kleine Portionen Raney-Nickel dazugegeben, bis sich die Lösung entfärbt und sämtliches Ausgangsprodukt verbraucht war, was durch eine Dünnschichtebromatographie verfolgt wurde (Hexane/Ethylacetat (9:1)). Danach wurde noch eine Stunde in der Siedehitze gerührt und der Katalysator heiß abfiltriert. Das Lösungsmittel wurde destillativ entfernt und der Rückstand mit Hexan umkristallisiert. Das Produkt 3c wurde durch Filtration als weißes Pulver (5,41 g, 22,79 mmol, 81 %) erhalten.

Smp. 96°C. C₁₇H₁₉N (237,34 g mol⁻¹): Ber. (%) C 86,03, H 8,07, N 5,90; Gef. C 86,16, H 8,18, N 5,94. IR(ATR): ν = 3420 (w), 3339 (w), 2957 (m), 2919 (w), 2870 (w), 1612 (w), 1582 (w), 1492 (w), 1449 (m), 1372 (w), 1353 (w), 1326 (m), 1277 (m), 1210 (w), 1135 (w), 1021 (w), 923 (w), 871 (m), 860 (m), 815 (m), 767 (s), 794 (m), 753 (m), 734 (s), 706 (m), 664 (s), 618 (s), 592 (m), 569 (s), 539 (s). ¹H NMR (CDCl₃, 500 MHz): *δ* = 7,55 (d, ³*J*_{HH} = 7,6 Hz, 1 H, Hₐᵣ), 7,48 (d, ³*J*_{HH} = 8,2 Hz, 1 H, Hₐᵣ), 7,25-7,29 (m, 2 H, Hₐᵣ), 7,17-7,20 (m, 1 H, Hₐᵣ), 6,65-6,67 (m, 2 H, Hₐᵣ), 3,76 (br. s, 2 H, NH₂), 1,89-2,02 (m, 4 H, CH₂), 0,33 (t, ³*J*_{HH} = 7,3 Hz, 6 H, CH₃) ppm, ¹³C NMR (CDCl₃, 126 MHz): *δ* = 151,7 (C), 148,9 (C), 145,9 (C), 142,0 (C), 132,9 (C), 126,6 (CH), 125,3 (CH), 122,6 (CH), 120,4 (CH), 118,3 (CH), 113,9 (CH), 109,8 (CH), 55,9 (9-C), 32.9 (CH₂), 8,5 (CH₃) ppm. ESI-MS (+10 V, MeOH, 0,1 % NH₄OAc): *m*/*z* 238,1 [M+H]⁺.

**9,9-Dipropyl-9*H*-fluoren-2-amin** (**3d**): 9,9-Dipropyl-2-nitro-9*H-*fluoren (**2d**) (6,52 g, 22,07 mmol) wurde in Ethanol (120 mL) gelöst und mit Hydrazin-Hydrat-Lösung (5,2 mL, 80%, 107 mmol) versetzt. Nach Erwärmen auf 55-60 °C wurden kleine Portionen Raney-Nickel dazugegeben, bis sich die Lösung entfärbt und sämtliches Ausgangsprodukt verbraucht war, was durch eine Dünnschichtchromatographie verfolgt wurde (Hexane/Ethylacetat (9:1)). Danach wurde noch eine Stunde in der Siedehitze gerührt und der Katalysator heiß abfiltriert. Das Lösungsmittel wurde destillativ entfernt und der Rückstand mit Hexan umkristallisiert. Das Produkt **3d** wurde durch Filtration als weißes Pulver (5,39 g, 20,31 mmol, 92 %) erhalten.

Smp. 121 °C. C₁₉H₂₃N (265,39 g mol⁻¹): Ber. (%) C 85,99, H 8,74, N 5,28; Gef. C 86,03, H 8,71, N 5,26. IR(ATR): ν = 3466 (m), 3375 (m), 3005 (w), 2949 (m), 2927 (m), 2897 (m), 2866 (m), 2842 (w), 1619 (m), 1493 (w), 1452 (s), 1397 (w), 1375 (w), 1351 (w), 1329 (w), 1289 (w), 1267 (m), 1210 (w), 1180 (w), 1132 (w), 1089 (w), 1023 (w), 931 (w), 865 (w), 818 (s), 789 (m), 734 (s), 590 (m), 557 (m). ¹H NMR (CDCl₃, 500 MHz): *δ* = 7,54 (d, ³*J*_{HH} = 7,4 Hz, 1 H, Hₐᵣ), 7,47 (d, 1 H, Hₐᵣ), 7,24-7,28 (m, 2 H, Hₐᵣ), 7,18 (t, ³*J*_{HH} = 7,2 Hz, 1 H, Hₐᵣ), 6,65-6,68 (m, 2 H, Hₐᵣ), 3,81 (br, s, 2 H, NH₂), 1,81-1,95 (m, 4 H, CH₂), 0,61-0,71 (m, 10 H, CH₂/CH₃) ppm. ¹³C NMR (CDCl₃, 126 MHz): *δ* = 152,6 (C), 149,7 (C), 145,7 (C), 141,5 (C), 132,5 (C), 126,6 (CH), 125,3 (CH), 122,5 (CH), 120,4 (CH), 118,3 (CH), 114,0 (CH), 109,8 (CH), 55,0 (9-C), 43,0 (CH₂), 17,1 (CH₂), 14,4 (CH₃) ppm. ESI-MS (+10 V, MeOH, 0,1 % NH₄OAc): *m*/*z* 266,2 [M + H], 531,1 [2 M + H]⁺.

**9,9-Dibutyl-9*H*-fluoren-2-amin (3e):** 9,9-Dibutyl-2-nitro-9*H*-fluoren (**2a**) (9,83 g, 30,39 mmol) wurde in Ethanol (200 mL) gelöst und mit Hydrazin-Hydrat-Lösung (4,7 mL, 80%, 77,4 mmol) versetzt. Nach Erwärmen auf 55-60 °C wurden kleine Portionen Raney-Nickel dazugegeben, bis sich die Lösung entfärbt und sämtliches Ausgangsprodukt verbraucht war, was durch eine Dünnschichtchromatographie verfolgt wurde (Hexane/Ethylacetat (9:1)). Danach wurde noch eine Stunde in der Siedehitze gerührt und der Katalysator heiß abfiltriert. Das Lösungsmittel wurde destillativ entfernt und der Rückstand mit Hexan umkristallisiert. Das Produkt 3e wurde durch Filtration als weißes Pulver (7,99 g, 27,23 mmol, 90 %) erhalten.

Smp. 94 °C. C₁₇H₁₉N (293,45 g mol⁻¹): Ber. (%) C 85,95, H 9,27, N 4,77; Gef. C 85,19, H 9,48, N 4,76. IR(ATR): ν = 3458 (w), 3369 (m), 3005 (w), 2954 (m), 2927 (m), 2847 (m), 1620 (m), 1494 (w), 1449 (m), 1375 (w), 1351 (w), 1331 (m), 1304 (m), 1286 (m), 1258 (w), 1210 (w), 1176 (w), 1134 (m), 1099 (w), 1023 (w), 931 (w), 867 (m), 817 (m), 771 (m), 737 (s), 586 (m), 561 (m). ¹H NMR (CDCl₃, 500 MHz): *δ* = 7,55 (d, ³*J*_{HH} = 7,6 Hz, 1 H, Hₐᵣ), 7,48 (d, ³*J*_{HH} = 8,2 Hz, 1 H, Hₐᵣ), 7,25-7,29 (m, 2 H, Hₐᵣ), 7,17-7,20 (m, 1 H, Hₐᵣ), 6,65-6,67 (m, 2 H, Hₐᵣ), 3,76 (br, s, 2 H, NH₂), 1,89-2,02 (m, 4 H, CH₂), 0,33 (t, ³*J*_{HH} = 7,3 Hz, 6 H, CH₃) ppm. ¹³C NMR (CDCl₃, 126 MHz): *δ* = 151,7 (C), 148,9 (C), 145,9 (C), 142,0 (C), 132,9 (C), 126,6 (CH), 125,3 (CH), 122,6 (CH), 120,4 (CH), 118,3 (CH), 113,9 (CH), 109,8 (CH), 55,9 (9-C), 32,9 (CH₂), 8,5 (CH₃) ppm. ESI-MS (+10 V, MeOH, 0,1 % NH₄OAc): *m*/*z* 294,2 [M + H], 587,1 [2 M + H]⁺.

**2,7-]Bis(9*H*-fluoren-2-yl)benzo[lmn][3,8]phenanthrolin-1,3,6,8(2H,7H)-tetron (5a, Bis- HFl-NTCDI):** Ein Gemisch aus Fluoren-2-amin **3a** (1,99 g, 11,0 mmol), Naphthalin-1,4,5,8-tetracarboxylsäuredianhydrid (**4**) (1,34 g, 5,0 mmol) und trockenes Pyridin (25 mL) wurden für 3 h in der Siedehitze gerührt. Der entstandene Feststoff wurde abfiltriert und mehrfach mit heißem Acetonitril gewaschen. Das Produkt **5a** fiel als orange-roter und unlöslicher Feststoff an (2,81 g, 4,09 mmol, 95 %).

Smp. 527 °C. Subl. 380 °C (10⁻⁷ mbar). C₂₂H₃₈N₂O₄ (594,61 g mol⁻¹). Ber. (%) C 80,80, H 3,73, N 4,71; Gef. C 79,92, H 3,58, N 4,71. IR(ATR): v = 3372 (w), 3053 (w), 1716 (m), 1665 (s), 1581 (m), 1455 (m), 1424 (w), 1350 (s), 1250 (s), 1195 (s), 1115 (w), 977 (m), 928 (w), 885 (w), 833 (m), 767 (m), 739 (s), 650 (w), 580 (m). ESI-MS (+25 V, MeOH, 0,1 % NH₄OAc): *m*/*z* 595,2 [M + H]⁺.

**2,7-Bis(9,9-dimethyl-9*H*-fluoren-2-yl)benzo[lmn][3,8]phenauthrolin-1,3,6,8(2H,7H)-tetron (5b, Bis-MeFl-NTCDI):** Ein Gemisch aus 9,9-Dimethyl-9*H-*fluoren-2-amin (3d, 4,04 g, 19,3 mmol), Naphthalin-1,4,5,8-tetracarboxylsäuredianhydrid (**4**, 2,57 g, 9,62 mmol) und trockenes Pyridin (40 mL) wurden für 3 h in der Siedehitze gerührt. Das Lösungsmittel wurde destillativ entfernt und der Rückstand im Vakuum (10⁻³ mbar) getrocknet. Der entstandene Feststoff wurde abfiltriert und mit heißem Acetonitril gewaschen. Eine Extraktion des Feststoffes mit Acetonitril ergaben 5,11 g eines orangefarbenen Pulvers (**5b,** 7,85 mmol, 82 %).

Smp. 387 °C. Subl. 360 °C (10⁻⁷ mbar). C₁₄H₃₀N₂O₄ (650,72 g mol⁻¹): Ber. (%) for C 81,21, H 4,65, N 4,30; Gef. C 81,19, H 4,65, N 4,31. IR(ATR): ν = 3372 (w), 3058 (w), 2962 (w), 2919 (w), 2856 (w), 1743 (w), 1713 (m), 1671 (s), 1655 (m), 1579 (m), 1447 (s), 1420 (m), 1334 (s), 1245 (s), 1192 (s), 1142 (w), 1115 (m), 1006 (w), 979 (m), 939 (w), 880 (m), 830 (m), 783 (w), 761 (s), 739 (s), 626 (w), 588 (w), 568 (m). ¹H NMR (CDCl₃, 500 MHz): *δ* = 8,87 (s, 2 H, Hₐᵣ), 7,91 (d, ³*J*_{HH} = 7,9 Hz, 1 H, Hₐᵣ), 7,77-7,79 (m, 1 H, Hₐᵣ),), 7,46-7,48 (m, 1 H, Hₐᵣ), 7,39 (s, 1 H, Hₐᵣ), 7,38-7,35 (m, 2 H, Hₐᵣ), 7,31 (d, ³*J*_{HH} = 7,9 Hz, 1 H, Hₐᵣ), ¹³C NMR (CDCl₃, 126 MHz): *δ* = 163,2 (C), 154,8 (C), 153,9 (C), 140,3 (C), 138,3 (C), 133,3 (C), 131,5 (CH), 127,8 (CH),), 127,2 (C), 127,1 (CH), 122,9 (CH), 122,7 (CH), 120,8 (CH), 120,4 (CH), 47,2 (9-C), 27,1 (CH₃) ppm. ESI-MS (+10 V, MeOH, 0,1 % NH₄OAc): m/z 651,4 [M + H]⁺.

**2,7-Bis(9,9-diethyl-9*H*-fluoren-2-yl)benzo[lmn][3,8]phenanthrolin-1,3,6,8(2H,7H)-tetron (5c, Bis-EtFl-NTCDI):** Ein Gemisch aus 9,9-Diethyl-9*H*-fluoren-2-amin (2,18 g, 9,19 mmol), Naphthalin-1,4,5,8-tetracarboxylsäuredianhydrid (**4**, 1,23 g, 4,59 mmol) und trockenes Pyridin (20 mL) wurden für 3 h in der Siedehitze gerührt. Das Lösungsmittel wurde destillativ entfernt und der Rückstand im Vakuum (10⁻³ mbar) getrocknet Der entstandene Feststoff wurde abfiltriert und mit heißem Acetonitril gewaschen.. Eine Extraktion des Feststoffes mit Acetonitril ergaben 2,89 g eines orangefarbenen Pulvers (**5c,** 4,09 mmol, 89 %).

Smp. 360 °C. SubL 340 °C (10⁻⁷ mbar). C₄₈H₃₈N₂O₄ (706,83 g mol⁻¹): Ber. (%) C 81,56, H 5,42, N 3,96; Gef. C 81,82, H 5,24, N 3,96. IR(ATR): ν = 3638 (w), 3077 (w), 2964 (w), 2918 (w), 2874 (w), 2853 (w), 1734 (w), 1715 (m), 1699 (m), 1974 (s), 1654 (m), 1636 (w), 1581 (m), 1487 (w), 1453 (m), 1420 (w), 1338 (s), 1246 (s), 1197 (m), 141 (w), 1118 (w), 1007 (w), 981 (m), 934 (w), 981 (w), 905 (w), 886 (w), 832 (w), 970 (m), 739 (s), 729 (s), 710 (w), 625 (m). ¹H NMR (CDCl₃, 500 MHz): *δ* = 8,86 (s, 1 H, Hₐᵣ), 7,90 (d, ³J_{HH} = 7,6 Hz, 1 H, Hₐᵣ), 7,76-7,78 (m, 1 H, Hₐᵣ), 7,36-7,38 (m, 3 H, Hₐᵣ), 7,30-7,32 (m, 2 H, Hₐᵣ), 2,06 (q, ³J_{HH} = 7,3 Hz, 4 H, CH₃), 0,43 (t, ³J_{HH} = 7,3 Hz, 6 H, CH₃) ppm. ¹³C NMR (CDCl₃, 126 MHz): *δ* = 163,1 (C), 151,2 (C), 150,4 (C), 142,3 (C), 140,5 (C), 133,2 (C), 131,4 (CH), 127,6 (CH), 127,2 (C), 127,1 (C), 127,0 (CH), 127,0 (CH), 123,3 (CH), 123,0 (CH), 120,4 (CH), 120,0 (CH), 56,4 (9-C), 32,7 (CH2), 8,6 (CH₃) ppm. ESI-MS (+10 V, MeOH, 0,1 % NH₄OAc): *m*/*z* 707,4 [M + H]⁺.

**2,7-Bis(9,9-dipropyl-9*H*-fluoren-2-yl)benzo[lmn][3,8]phenanthrolin-1,3,6,8(2H,7H)-tetron (5d, Bis-PrFl-NTCDI):** Ein Gemisch aus 9,9-Dipropyl-9*H*-fluoren-2-amin (5,28 g, 19,9 mmol), Naphthalin-1,4,5,8-tetracarboxylsäuredianhydrid (4, 2,67 g, 9,95 mmol) und trockenes Pyridin (50 mL) wurden für 3 h in der Siedehitze gerührt. Der entstandene Feststoff wurde abfiltriert und mit heißem Acetonitril gewaschen. Das Lösungsmittel wurde destillativ entfernt und der Rückstand im Vakuum (10⁻³ mbar) getrocknet. Der entstandene Feststoff wurde abfiltriert und mit heißem Acetonitril gewaschen. Eine Extraktion des Feststoffes mit Acetonitril ergaben 5,69 g eines orangefarbenen Pulvers (**5d**, 7,46 mmol, 75 %).

Smp. 343 °C. Subl. 360°C (10⁻⁷ mbar). C₅₂H₄₆N₂O₄ (762,93 g mol⁻¹): Ber. (%) C 81,86, H 6,08, N 3,67; Gef. C 81,46, H 6,20, N 3,76. IR(ATR): ν = 3663 (w), 3038 (m), 2955 (m), 2930 (w), 2869 (w), 2836 (w), 1714 (m), 1678 (s), 1654 (m), 1580 (m), 1453 (m), 1336 (s), 1246 (s), 1211 (m), 1196 (m), 1118 (m), 1006 (w), 978 (m), 940 (m), 885 (m), 838 (m), 784 (w), 768 (s), 743 (s), 652 (m), 588 (w). ¹H NMR (CDCl₃, 500 MHz); *δ* = 8,87 (s, 1 H, Hₐᵣ), 7,89 (d, ³*J*_{HH} = 7,7 Hz, 1 H, Hₐᵣ), 7,75-7,77 (m, 1 H, Hₐᵣ), 7,35-7,41 (m, 3 H, Hₐᵣ), 7,29-7,32 (m, 2 H, Hₐᵣ), 1,96-1,99 (m, 4 H, CH₂), 0,68-0,86 (m, 10 H, CH₃ / CH₂) ppm. ¹³C NMR (CDCl₃, 126 MHz): *δ* = 163,1 (C), 151,9 (CH), 151,2 (CH), 141,8 (C), 140,1 (C), 133,1 (C), 131,4 (CH), 127,6 (CH), 127,2 (C), 127,1 (C), 127,0 (CH), 123,3 (CH), 123,0 (CH), 120,4 (CH), 120,1 (CH), 55,5 (9-C), 42,6 (CH₂), 17,3 (CH₂), 14,6 (CH₃) ppm. ESI-MS (+25 V, MeOH, 0,1 % NH₄OAc): *m*/*z* 763,5 [M + H]⁺.

**2,7-Bis(9,9-dibutyl-9*H*-fluoren-2-yl)benzo[lmn][3,8]phenanthrolin-1,3,6,8(2H,7H)-tetron (5e, Bis-BuFl-NTCDI):** Ein Gemisch aus 9,9-Dibutyl-9*H-*fluoren-2-amin (2,93 g, 10 mmol), Naphthalin-1,4,5,8-tetracarboxylsäuredianhydrid (**4**, 1,34 g, 5 mmol) und trockenes Pyridin (40 mL) wurden für 3 h in der Siedehitze gerührt. Der entstandene Feststoff wurde abfiltriert und mit heißem Acetonitril gewaschen. Das Lösungsmittel wurde destillativ entfernt und der Rückstand im Vakuum (10⁻³ mbar) getrocknet. Der entstandene Feststoff wurde abfiltriert und mit heißem Acetonitril gewaschen. Eine Extraktion des Feststoffes mit Acetonitril ergaben 3,40 g eines orangefarbenen Pulvers (**5e,** 4,15 mmol, 80%).

Smp. 288 °C. Subl. 320 °C (10⁻⁷ mbar). C₅₆H₅₄N₂O₄ (819,05 g mol⁻¹): Ber. (%) C 82,12, H 6,65, N 3,42; Gef. C 81,93, H 6,82, N 3,45. IR(ATR): ν = 3078 (w), 2954 (m), 2926 (m), 2858 (m), 1734 (w), 1715 (s), 1673 (s), 1654 (s), 1581 (m), 1451 (m), 1338 (s), 1243 (s), 1198 (m), 1118 (w), 979 (m), 886 (m), 831 (m), 769 m), 739 (s), 648 (w). ¹H NMR (CDCl₃, 500 MHz): *δ* = 8,87 (s, 1 H, Hₐᵣ), 7,89 (d, ³*J*_{HH} = 6,6 Hz, 1 H, Hₐᵣ), 7,76-7,77 (m, 1 H, Hₐᵣ), 7,35-7,40 (m, 3 H, Hₐᵣ), 7,30-7,31 (m, 2 H, Hₐᵣ), 1,96-2,03 (m, 4 H, CH₂), 1,07-1,15 (m, 4 H, CH₂), 0,64-0,85 (m, 10 H, CH₃ / CH₂) ppm. ¹³C NMR (CDCl₃, 126 MHz): *δ* = 163,1 (C), 151,9 (C), 151,1 (C), 141,9 (C), 140,2 (C), 133,1 (C), 131,4 (CH), 127,5 (CH), 127,2 (C), 127,1 (C), 127,0 (CH), 123,3 (CH), 123,0 (CH), 120,4 (CH), 120,1 (CH), 55,3 (9-C), 40,0 (CH2), 26,0 (CH2), 23,0 (CH2), 13,8 (CH3) ppm. ESI-MS (+10 V, MeOH, 0,1 % NH₄OAc): *m*/*z* 819,6 [M + H]⁺.

### Ausführungsbeispiel 1:

Dokumentation des Absorptionsverhaltens und der Oberflächenstruktur einer aufgedampften dünnen Schicht N,N-Bis(fluoren-2-yl)-naphthalintetracarboxydiimid (Bis-HFl-NTCDI). Es wird der Nachweis geführt, dass Bis-HFl-NTCDI keine parasitäre Absorption von Licht im sichtbaren Bereich zeigt. Eine mikroskopische Aufnahme der Oberfläche soll die geringe Oberflächenrauigkeit belegen.

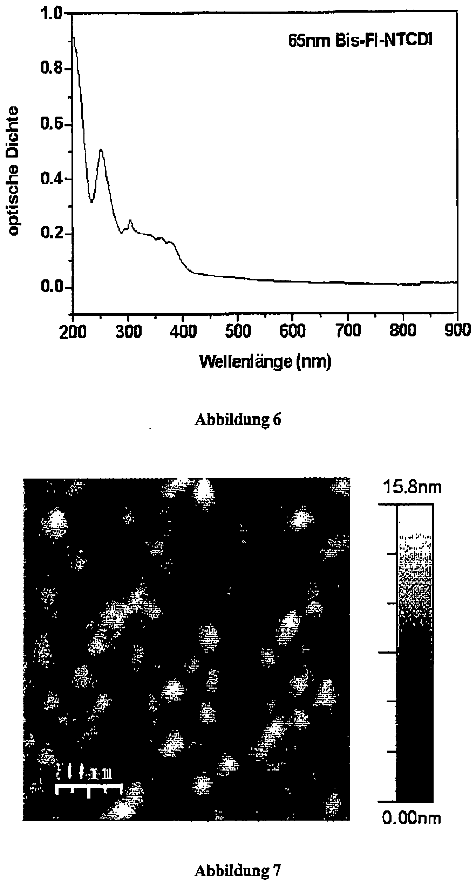

Abbildung 6 zeigt das Absorptionsverhalten eines im Vakuum auf ein Glassubstrat abgeschiedenen Dünnfilms mit einer Schichtdicke von 65 nm. Die optische Bandlücke kann anhand der Position der Absorptionskante bestimmt werden und ergibt sich für Bis-HFl-NTCDI zu 3,02 eV, was gleichbedeutend mit der geforderten Transparenz im sichtbaren Bereich des Sonnenspektrums ist. Eine mit dem Rasterkraftmikroskop (AFM) untersuchte Oberflächenstruktur einer 65nm dünnen aufgedampften Schicht zeigt eine sehr geringe mittlere quadratische Rauigkeit (rms) von 2,4 nm (Abbildung 7). Bei Raumtemperatur (Substrat) gedampfte Schichten sind demzufolge glatt und geschlossen, was ein gleichmäßiges Wachstum der nachfolgenden Schichten gewährleistet.

### Ausführungsbeispiel 2:

Das Material Bis-BuFl-NTCDI wurde mit Hilfe der Cyclovoltammetrie untersucht, um das Energieniveau des LUMO berechnen zu können und die Reversibilität des Reduktionsprozesses zu belegen.

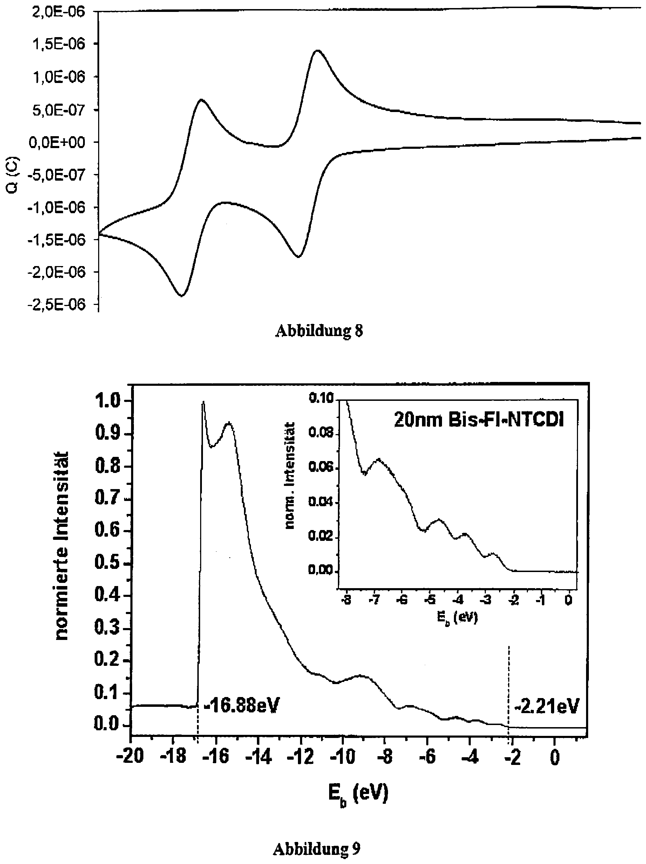

Für die Cyclovoltammetrie wurde eine typische Elektrodenkonfiguration verwendet, bestehend aus einer Arbeitselektrode aus Platin, eine Platin-Draht-Gegenelektrode und einem elektrochemisch mit Silberchlorid beschichtetem Silberstab als Referenzelektrode. Es wurde mit einer Geschwindigkeit von 100 mV s⁻¹ in entgastem Dichlormethan (HPLC-Qualität) unter Zusatz von Tetra-*n-*butylammoniumhexafluorophosphat (TBAPF, 0,1 mol L⁻¹) als Elektrolyt und internem Standard Ferrocen (*E*°_{vac}(Fc/Fc⁺) = -4,78 eV) gearbeitet. Abbildung 8 zeigt zwei symmetrische Peaks, die den beiden ersten Reduktionspotentialen zuzuordnen sind. Aus dem Abstand der Potentiale zum Ferrocen-Redox-Potential (Fc/Fc⁺) konnten die Energieniveaus des jeweiligen LUMOs der Verbindungen 5a bis 5d im Bereich von-3,70 bis -3,72 eV berechnet werden.

Das Ionisationspotential (E_{HOMO}) eines Dünnfilmes von Bis-Fl-NTCDI wurde mit Hilfe von ultravioletter Photoelektronenspektroskopie (UPS) bestimmt. Dazu wurde ein 20 nm dünner Film Bis-Fl-NTCDI im Hochvakuum auf einem frisch gesputterten Silbersubstrat abgeschiedenen. Anschließend wurde die Probe ohne Unterbrechung des Vakuums in die Messkammer transferiert. Abbildung 9 zeigt das resultierende UP-Spektrum, aus dem sich das Ionisationspotential zu 6,55eV berechnen lässt.

### Ausführungsbeispiel 3:

Es soll die Dotierbarkeit von Bis-Fl-NTCDI mit bekannten molekularen n-Dotanden sowie die signifikante Erhöhung der Leitfähigkeit dotierter Dünnschichten mit Hilfe von Querleitfähigkeitsmessungen demonstriert werden.

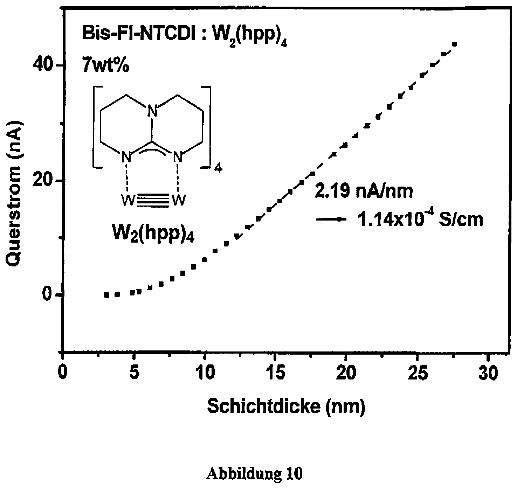

Bis-HFl-NTCDI wurde durch Ko-Verdampfung mit 7% (Gewichtsprozent) W₂(hpp)₄ auf ein mit Aluminiumelektroden beschichtetes Glassubstrat aufgebracht Schon während des Abscheidungsprozesses im Hochvakuum kann durch Anlegen einer Spannung zwischen den Kontakten mit einer 2-Punkt Methode der dann fließende Strom gemessen werden. Aus der Geometrie der Kontakte und der Schichtdicke der Probe ergibt sich die Leitfähigkeit des dotierten Materials. Wie aus Abbildung 10 zu sehen ist, bilden sich ab einer Schichtdicke von 3 nm des organischen Halbleitermaterials geschlossene Perkolationspfade zwischen den Elektroden aus und es fließt ein messbarer Querstrom. Eine vollständig geschlossene Schicht wird bei einer Filmdicke von ca. 9 nm erreicht Die Querleitfähigkeit von aufgereinigten undotierten organischen Materialien ist kleiner als 10⁻¹⁰ S cm⁻¹, während die oben beschriebene Dotierung zu einer Erhöhung der Querleitfähigkeit auf 1,1·10⁻⁴ S cm⁻¹ führt.

### Ausführunssbeispiel 4:

Dokumentation der Verwendung von Bis-HFl-NTCDI in der Elektronentransportschicht einer Organischen Solarzelle und der Langzeitstabilität im Vergleich zum Standardelektronentransportsystem C₆₀. Für den Vergleich der ETM in Bauteilen wird eine p-i-n Solarzelle mit einer Absorber-Mischschicht herangezogen.

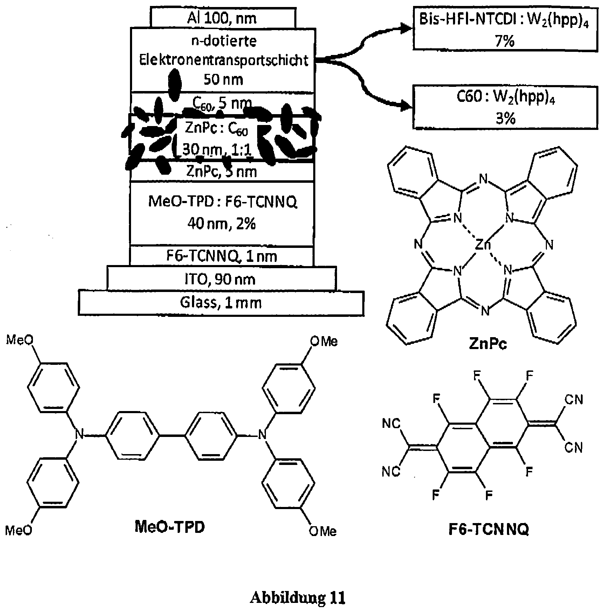

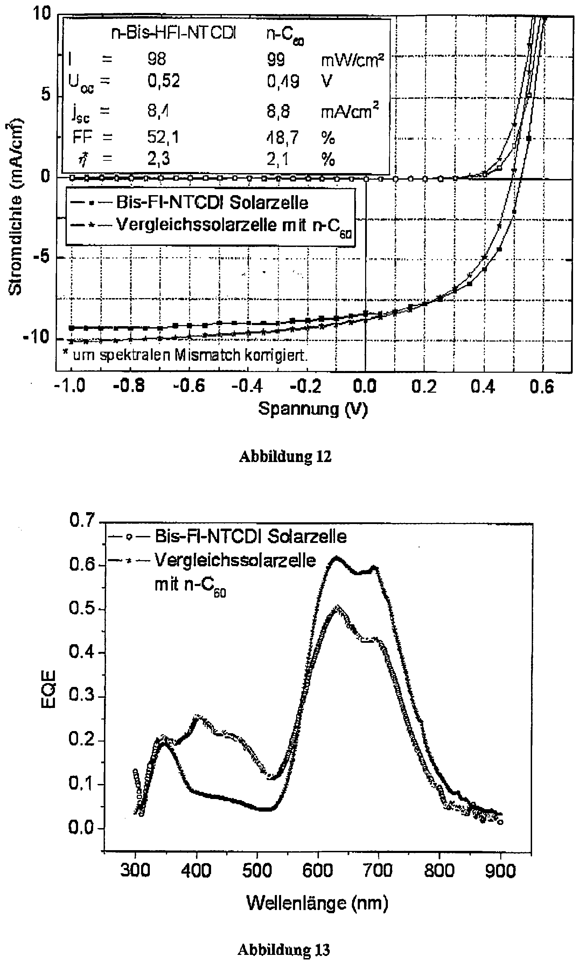

Es wurde eine organische p-i-n Solarzelle entsprechend Abbildung 11 hergestellt. Hierzu wurde ein mit Indium-Zinn-Oxid Kontakten beschichtetes Glassubstrat zunächst im Ultraschallbad mit NMP (N-Methyl-2-pyrrolidon), deionisiertem Wasser und Ethanol gereinigt und anschließend für mit einem Sauerstoffplasma behandelt. Das auf diese Weise gereinigte Substrat wurde nun in einer Vakuumanlage mit 1 nm F₆-TCNNQ, gefolgt von 40 nm F₆-TCNNQ dotiertem N,N,N',N'-Tetrakis(4-methoxyphenyl)-benzidin (MeO-TPD, 2% F₆-TCNNQ) als Löchertransportsystem beschichtet. Die photoaktiven Schichten werden von 5 nm Zinkphtalocyanin (ZnPc), einer 30 nm dicken Mischschicht aus ZnPc und dem Fulleren C₆₀ in einem Mischverhältnis 1:1 und einer weiteren 5 nm dicken C₆₀ Einzelschicht gebildet. Es folgt eine 50 nm dicke n-dotierte Elektronentransportschicht aus C₆₀ (3% W₂(hpp)₄), bzw. Bis-HFl-NTCDI (7% W₂(hpp)₄). Die Gegenelektrode wird von einer 100 nm dicken Aluminiumschicht gebildet Diese Schichtfolge entspricht einer p-i-n Solarzelle entsprechend dem derzeitigen Stand der Technik (C. Falkenberg et al., J. Appl. Phys. 104 (3), 034506, 2008). Das Aufbringen aller Materialien erfolgte durch thermische Verdampfung bei einem Basisdruck von im Durchschnitt 10⁻⁷ mbar. Das fertige Bauelement wurde in einer Stickstoffatmosphäre mit einem Deckglas verkapselt und im Anschluss unter einem simulierten Sonnenspektrum bei einer Mismatch korrigierten Intensität von knapp 100 mW/cm² vermessen. Abbildung 12 zeigt die zugehörigen Strom-Spannungs-Kennlinien beider Vergleichszellen. Die Solarzelle mit Bis-HFl-NTCDI zeigt eine gegenüber der Referenzzelle mit n-C₆₀ erhöhte Leerlaufspannung von 0,52 V im Vergleich zu 0,49 V und einen höheren Füllfaktor von 52,1 % im Vergleich zu 48,7 % für die Vergleichssolarzelle. In der Folge ergibt sich eine erhöhte Effizienz für die Bis-HFl-NTCDI-beinhaltende Solarzelle. Weiterhin ist in Abbildung 13 die externe Quanteneffizienz beider Solarzellen dargestellt, die einen deutlich gesteigerten Anteil des Beitrags von C₆₀ (300 bis 500 nm) zum Photostrom durch Verwendung von Bis-HFl-NTCDI zeigt. Bei der mit n-C₆₀ als ETM prozessierten Zelle führt die parasitäre Absorption zu einem deutlich geringeren Beitrag des als Absorber verwendeten i-C₆₀ in diesem Bereich.

### Ausführungsbeispiel 5:

Dokumentation der Langzeitstabilität einer organischen Solarzelle mit Bis-HFl-NTCDI als Elektronentransportschicht.

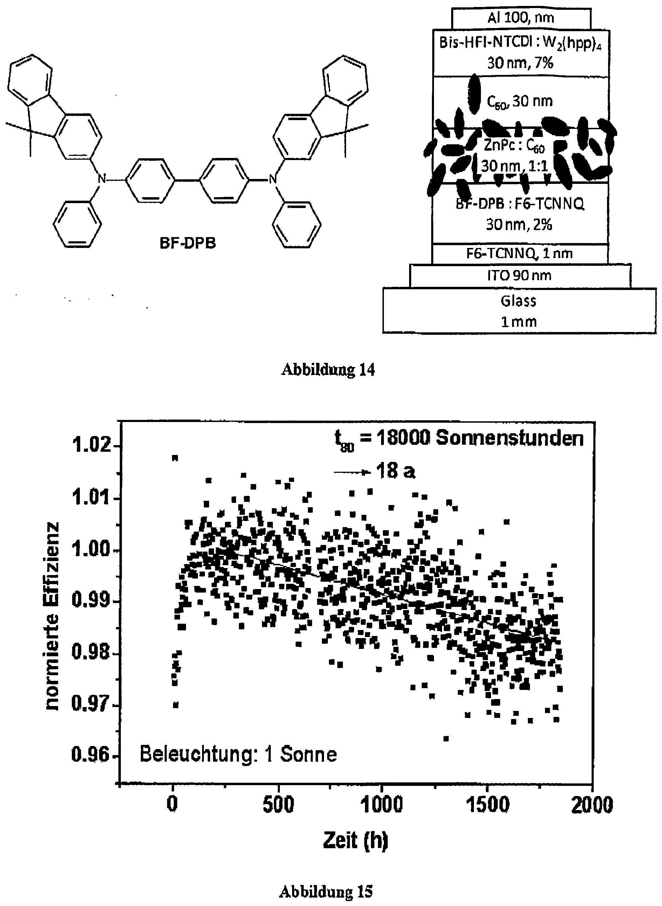

Es wurde eine organische p-i-n Solarzelle entsprechend Abbildung 14 hergestellt. Hierzu wurde ein mit Indium-Zinn-Oxid Kontakten beschichtetes Glassubstrat zunächst im Ultraschallbad mit NMP (N-Methyl-2-pyrrolidon), deionisiertem Wasser und Ethanol gereinigt und anschließend für mit einem Sauerstoffplasma behandelt. Das auf diese Weise gereinigte Substrat wurde nun in einer Vakuumanlage mit 1 nm F₆-TCNNQ gefolgt von 30 nm F₆-TCNNQ dotiertem N,N'-((Diphenyl-N,N'-bis)9,9,-dimethyl-fluoren-2-yl)benzidin (BF-DPB, 2% F₆-TCNNQ) als Löchertransportsystem beschichtet. Die photoaktiven Schichten wurden von einer 30 nm dicken Mischschicht aus Zinkphthalocyanin (ZnPc) und Fulleren C₆₀ in einem Mischverhältnis 1:1 und einer weiteren 30 nm dicken C₆₀ Einzelschicht gebildet. Es folgt eine 30 nm dicke Elektronentransportschicht aus Bis-HFl-NTCDI, das mit 7% W₂(hpp)₄ n-dotiert ist. Die Gegenelektrode wird von einer 100 nm dicken Aluminiumschicht gebildet. Das fertige Bauelement wurde in einer Stickstoffatmosphäre mit einem Deckglas verkapselt und bei 50°C und Beleuchtung mit weißen LEDs bei einer Leistung von 112 mW cm⁻² gealtert. Abbildung 15 verdeutlicht die Entwicklung der Effizienz im zeitlichen Verlauf. Bei einer Intensität von knapp einer Sonne wird nach 18000 h ein Rückgang der Effizienz um 20 Prozentpunkte registriert. Da es sich dabei um reine Sonnenstunden handelt, kann die Lebensdauer bezogen auf 80 % der Ausgangseffizienz bei normalem Tag-Nacht Rhythmus auf ca. 18 Jahre extrapoliert werden.

In Bezug auf die Anwendung von Bis-Fl-NTCDI als Elektronentransportmaterial in p-i-n Solarzellen lässt sich schlussfolgern, dass der Austausch von Fulleren C₆₀ durch die erfindungsgemäßen Bis-Fl-NTCDI-Verbindungen zu verbesserten Leistungen der Solarzellen führt. Die erfindungsgemäße Materialklasse ist außerordentlich temperaturstabil was eine hohe Stabilität der Bauteile mit nach sich zieht

## Patentansprüche

1. Organische Solarzelle, **dadurch gekennzeichnet, dass** die organische Solarzelle mindestens eine N,N-Bis(fluoren-2-yl)-naphthalintetracarboxydiimid Verbindung der allgemeinen chemischen Formel 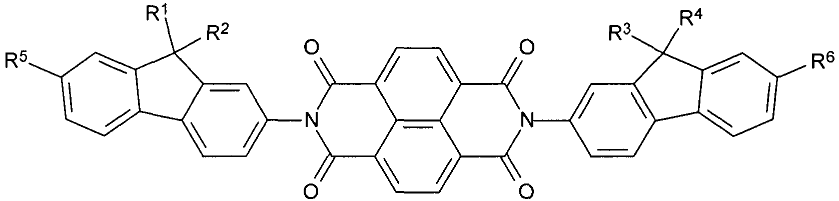 enthält, wobei R¹-R⁶ unabhängig ausgewählt ist aus Wasserstoff, Halogen, unsubstituiertem oder substituiertem, gesättigtem oder ungesättigtem C₁-C₂₀-Alkyl, C₁-C₂₀-Heteroalkyl, C₁-C₂₀-Alkenyl, C₁-C₂₀-Heteroalkenyl, C₁-C₂₀-Alkinyl, C₁-C₂₀-Heteroalkinyl, C₆-C₂₀-Aryl, C₆-C₂₀-Heteroaryl, gesättigtem oder ungesättigtem Carbo- oder Heterocyclus, die gleich oder verschieden sein können, wobei zwei benachbarte Reste R¹-R⁶ auch Bestandteil eines weiteren gesättigten oder ungesättigten, carbocyclischen oder heterocyclischen Rings sein können, wobei der Ring C, N, O, S, Si und Se umfassen kann.

2. Organische Solarzelle nach Anspruch 1, **dadurch gekennzeichnet, dass** diese aus einer Folge von organischen Dünnschichten und Kontaktschichten mit mindestens einer dotierten Transportschicht (2, 4, 6, 8) und mindestens einer photoaktiven Schicht besteht, die in einer p-i-n-, n-i-p-, n-i-M oder M-i-n-Dioden-Struktur aus jeweils einer oder mehreren p-, i- oder n-Schichten angeordnet sind.

3. Organische Solarzelle nach Anspruch 1, **dadurch gekennzeichnet, dass** diese aus einer Folge von organischen Dünnschichten und Kontaktschichten mit mindestens einer dotierten Transportschicht (2, 4, 6, 8) und mindestens einer photoaktiven Schicht besteht, die in einer p-i-n-, n-i-p-, n-i-M oder M-i-n-Dioden-Struktur aus jeweils einer oder mehreren p-, i- oder n-Schichten angeordnet sind, wobei mindestens eine Elektronentransportschicht (n-Schicht) aus mindestens, aber nicht ausschließlich, einer N,N-Bis(fluoren-2-yl)-naphthalintetracarboxydiimid Verbindung der allgemeinen chemischen Formel 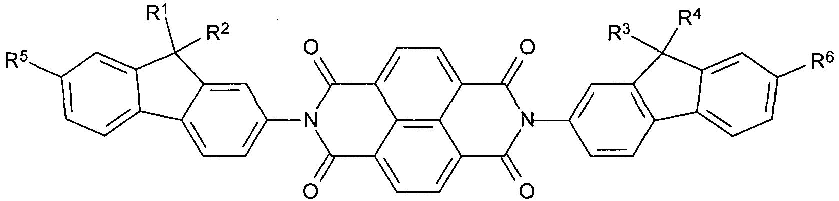 besteht.

4. Organische Solarzelle nach Anspruch 1, **dadurch gekennzeichnet, dass** die organische Solarzelle eine so genannte Mehrfachsolarzelle ist, das heißt aus einem Stapel zweier oder mehrerer organischer Einzelsolarzellen besteht, welche durch einen so genannten "Konversionskontakt" (5) verbunden sind, der der Rekombination von Elektronen und Löchern dient und der aus mindestens einer Schicht aus organischen, anorganischen oder einer Kombination aus organischen oder anorganischen Materialien besteht.

5. Organische Solarzelle nach Ansprüchen 1-4, **dadurch gekennzeichnet, dass** die organische Solarzelle neben mindestens einer N,N-Bis(fluoren-2-yl)-naphthalintetracarboxydiimid Verbindung auch andere Materialien enthält, die bevorzugt negative Ladungen (Elektronen) leiten, auch "electron transport layer" (ETL) genannt.

6. Organische Solarzelle nach Ansprüchen 1-4, **dadurch gekennzeichnet, dass** die organische Solarzelle Antidiffusionsschichten aus Metallen oder Übergangsmetallen enthält (beispielsweise, aber nicht beschränkt auf Ti, Pd, Cr).

7. Organische Solarzelle nach Ansprüchen 1-4, **dadurch gekennzeichnet, dass** die organische Solarzelle Kontakte aus dünnen Metallschichten, bestehend aus einem Metall wie beispielsweise, aber nicht beschränkt auf, Aluminium, Silber, Gold, Ytterbium, Chrom, Nickel, Magnesium, Eisen, oder einer Kombination aus mehreren Metallen enthält.

8. Organische Solarzelle nach Ansprüchen 1-4, **dadurch gekennzeichnet, dass** die organische Solarzelle Konversionskontakte (8) aus dünnen Metallschichten, anorganischen Materialien (beispielsweise, aber nicht beschränkt auf so genannte Nanokristalle bestehend aus kleiner als 100 nm großen Clustern aus Metall oder anorganischem Material) oder organischen Materialien (beispielsweise, aber nicht beschränkt auf dotierte oder undotierte Moleküle oder Polymere) enthält.

9. Organische Solarzelle nach Ansprüchen 1-4, **dadurch gekennzeichnet, dass** die organische Solarzelle auf einem Substrat (0) aus beispielsweise, aber nicht beschränkt auf Glas, Aluminiumfolie, Stahl, textilem Material oder Plastikfolie hergestellt ist.

10. Organische Solarzelle nach Ansprüchen 1-4, **dadurch gekennzeichnet, dass** die organische Solarzelle so genannte p-Dotanden enthält, die als Elektronen-Akzeptoren dienen, welche beispielsweise in, aber nicht beschränkt auf Löchertransportschichten (HTL) eingesetzt werden.

11. Organische Solarzelle nach Ansprüchen 1-4, **dadurch gekennzeichnet, dass** die organische Solarzelle so genannte n-Dotanden enthält, die als Elektronen-Donatoren dienen, welche beispielsweise in, aber nicht beschränkt auf Elektronentransportschichten (ETL) eingesetzt werden.

12. Organische Solarzelle nach Ansprüchen 1-4, **dadurch gekennzeichnet, dass** die organische Solarzelle Schichtfolgen aus stark dotierten Materialien enthält, wobei die Schichtfolge mindestens ein p-dotiertes und mindestens ein n-dotiertes Material enthält und insgesamt als Ladungsträgerkonversionskontakt dient.

13. Organische Solarzelle nach Ansprüchen 1-4, **dadurch gekennzeichnet, dass** die organische Solarzelle Materialien enthält, die der Verkapselung dienen.

14. Organische Solarzelle nach Ansprüchen 1-4, **dadurch gekennzeichnet, dass** die organische Solarzelle Deckschichten zur Lichteinkopplung enthält.

15. Verfahren zur Herstellung einer organischen Solarzelle nach einem der Ansprüche 1-14.

16. Verfahren zur Herstellung einer organischen Solarzelle nach Anspruch 15
**dadurch gekennzeichnet, dass** die organische Solarzelle oder Teile davon durch thermisches Verdampfen oder andere thermische Verfahren hergestellt werden.

17. Verfahren zur Herstellung einer organischen Solarzelle nach Anspruch 15,
**dadurch gekennzeichnet, dass** die organische Solarzelle oder Teile davon durch Rotationsbeschichtung/Aufschleudern ("spincoating"), Eintauchen ("dip-coating"), Auftropfen ("drop-casting"), Rakeln ("doctor-blading"), chemische Dampf-Phasen Deposition ("chemical vapour phase deposition", CVPD, oder "organic vapour phase deposition", OVPD), Elektrodeposition oder andere chemische, elektrochemische oder nasschemische Verfahren hergestellt wurde.

18. Verfahren zur Herstellung einer organischen Solarzelle nach Anspruch 15,
**dadurch gekennzeichnet, dass** die organische Solarzelle oder Teile davon durch Siebdruck, Offset-Druck, Inkjet Printing oder andere auf Drucken basierende Verfahren hergestellt wurde.

19. Verfahren zur Herstellung einer organischen Solarzelle nach Anspruch 15,
**dadurch gekennzeichnet, dass** die organische Solarzelle oder Teile davon durch "magnetron sputtering" oder andere, auf Kathodenzerstäubung basierende Verfahren hergestellt wurde.

20. Verfahren zur Herstellung einer organischen Solarzelle nach Anspruch 15,
**dadurch gekennzeichnet, dass** die organische Solarzelle oder Teile davon durch Molekularstrahlepitaxie oder vergleichbare Verfahren hergestellt wurde.

21. Verfahren zur Herstellung einer organischen Solarzelle nach Anspruch 15,
**dadurch gekennzeichnet, dass** die organische Solarzelle oder Teile davon durch Auflaminieren oder vergleichbare Verfahren hergestellt wurde.

22. Verfahren zur Herstellung einer organischen Solarzelle nach Anspruch 15,
**dadurch gekennzeichnet, dass** die organische Solarzelle oder Teile davon durch selbst-strukturierende Monoschichten (sogenannte "self-assembled monolayers") oder vergleichbare Verfahren hergestellt wurde.

23. Verfahren zur Herstellung einer organischen Solarzelle nach Anspruch 15,
**dadurch gekennzeichnet, dass** die organische Solarzelle oder Teile davon durch Verwendung der allgemeinen chemischen Formel 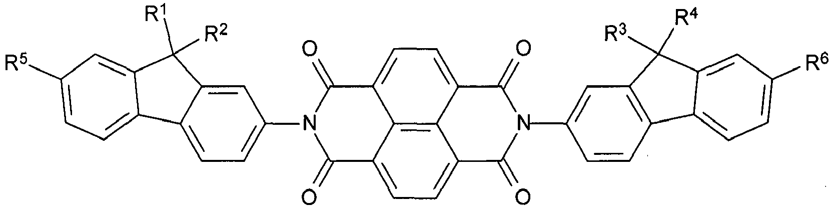 als Monomer hergestellt wurde, das *in situ* durch Lichteinwirkung, radikalisch, katalytisch, thermisch oder vergleichbare Verfahren polymerisiert, um eine Quervernetzung der Schicht zu erreichen.

## Claims

1. An organic solar cell, **characterized in that** the organic solar cell contains at least one N,N-bis(fluoren-2-yl)-naphthalenetetracarboxydiimide compound with the general chemical formula 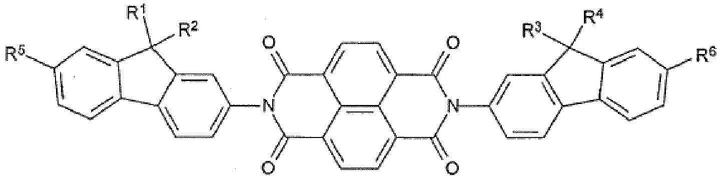 wherein R¹-R⁶ is independently selected from hydrogen, halogen, unsubstituted or substituted, saturated or unsaturated C₁-C₂₀ alkyl, C₁-C₂₀ heteroalkyl, C₁-C₂₀ alkenyl, C₁-C₂₀ heteroalkenyl, C₁-C₂₀ alkynyl, C₁-C₂₀ heteroalkynyl, C₆-C₂₀ aryl, C₆-C₂₀ heteroaryl, saturated or unsaturated carbocycles or heterocycles which may be identical or different, wherein two adjacent R¹-R⁶ residues may also be a component of a further saturated or unsaturated, carbocyclic or heterocyclic ring, wherein the ring may comprise C, N, O, S, Si and Se.

2. The organic solar cell according to claim 1, **characterized in that** it consists of a sequence of organic thin layers and contact layers with at least one doped transport layer (2, 4, 6, 8) and at least one photoactive layer, which are disposed in a p-i-n, n-i-p, n-i-M or M-i-n diode structure respectively formed from one or more p-, i- or n-layers.

3. The organic solar cell according to claim 1, **characterized in that** it consists of a sequence of organic thin layers and contact layers with at least one doped transport layer (2, 4, 6, 8) and at least one photoactive layer, which are disposed in a p-i-n, n-i-p, n-i-M or M-i-n diode structure respectively formed from one or more p-, i- or n-layers, wherein at least one electron transport layer (n-layer) consists of at least one but not exclusively one N,N-bis(fluoren-2-yl)-naphthalenetetracarboxydiimide compound with general chemical formula

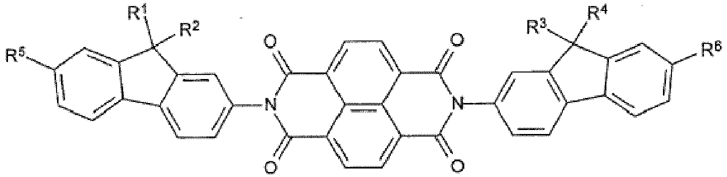

4. The organic solar cell according to claim 1, **characterized in that** the organic solar cell is what is known as a multiple solar cell, i.e. formed by a stack of two or more organic single solar cells which are connected by means of what is known as a "conversion contact" (5) which acts to recombine electrons and holes and which consists of at least one layer of organic, inorganic or a combination of organic or inorganic materials.

5. The organic solar cell according to claims 1 - 4, **characterized in that** in addition to at least one N,N-bis(fluoren-2-yl)-naphthalenetetracarboxydiimide compound, the organic solar cell also contains other materials which preferably conduct negative charges (electrons), also known as the "electron transport layer" (ETL).

6. The organic solar cell according to claims 1 - 4, **characterized in that** the organic solar cell contains anti-diffusion layers formed from metals or transition metals (for example, but not limited to Ti, Pd, Cr).

7. The organic solar cell according to claims 1 - 4, **characterized in that** the organic solar cell contains contacts formed from thin metal layers consisting of a metal, for example but not limited to aluminium, silver, gold, ytterbium, chromium, nickel, magnesium, iron or a combination of several metals.

8. The organic solar cell according to claims 1 - 4, **characterized in that** the organic solar cell contains conversion contacts (8) formed from thin metal layers, inorganic materials (for example but not limited to what are known as nanocrystals consisting of clusters of metal or inorganic material with dimensions of less than 100 nm) or organic materials (for example but not limited to doped or undoped molecules or polymers).

9. The organic solar cell according to claims 1 - 4, **characterized in that** the organic solar cell is produced from a substrate (0) formed, for example but not limited to, glass, aluminium foil, steel, textile material or plastic film.

10. The organic solar cell according to claims 1 - 4, **characterized in that** the organic solar cell contains what are known as p-dopants which act as electron acceptors which are inserted in, for example but not limited to, hole transport layers (HTL).

11. The organic solar cell according to claims 1 - 4, **characterized in that** the organic solar cell contains what are known as n-dopants which act as electron donors which are inserted in, for example but not limited to, electron transport layers (ETL).

12. The organic solar cell according to claims 1 - 4, **characterized in that** the organic solar cell contains sequences of layers of strongly doped materials, wherein the sequence of layers contains at least one p-doped and at least one n-doped material and in total acts as a charge carrier conversion contact.

13. The organic solar cell according to claims 1 - 4, **characterized in that** the organic solar cell contains materials which are used for encapsulation.

14. The organic solar cell according to claims 1 - 4, **characterized in that** the organic solar cell contains cover layers for light coupling.

15. A process for the production of an organic solar cell according to one of claims 1 - 14.

16. The process for the production of an organic solar cell according to claim 15, **characterized in that** the organic solar cell or parts thereof is/are produced by thermal vapour evaporation or other thermal processes.

17. The process for the production of an organic solar cell according to claim 15, **characterized in that** the organic solar cell or parts thereof is/are produced by spin coating, dip coating, drop casting, doctor blading, chemical vapour phase deposition (CVPD) or organic vapour phase deposition (OVPD), electrodeposition or other chemical, electrochemical or wet chemical processes.

18. The process for the production of an organic solar cell according to claim 15, **characterized in that** the organic solar cell or parts thereof is/are produced by screen printing, offset printing, inkjet printing or other printing-based processes.

19. The process for the production of an organic solar cell according to claim 15, **characterized in that** the organic solar cell or parts thereof is/are produced by magnetron sputtering or other cathode-sputtering-based processes.

20. The process for the production of an organic solar cell according to claim 15, **characterized in that** the organic solar cell or parts thereof is/are produced by molecular beam epitaxy or similar processes.

21. The process for the production of an organic solar cell according to claim 15, **characterized in that** the organic solar cell or parts thereof is/are produced by lamination or similar processes.

22. The process for the production of an organic solar cell according to claim 15, **characterized in that** the organic solar cell or parts thereof is/are produced by self-assembled monolayers or similar processes.

23. The process for the production of an organic solar cell according to claim 15, **characterized in that** the organic solar cell or parts thereof is/are produced using the general chemical formula 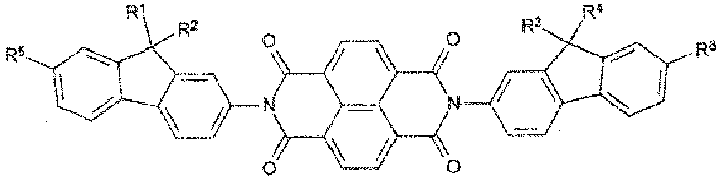 as a monomer which is polymerized in situ by the action of light, or by a radical, catalytic, thermal or similar process, in order to cross-link the layer.

## Revendications

1. Cellule solaire organique, **caractérisée en ce que** la cellule solaire organique contient au moins un composé N,N-bis(fluorène-2-yl) naphtaline-tétracarboxydiimide de la formule chimique générale 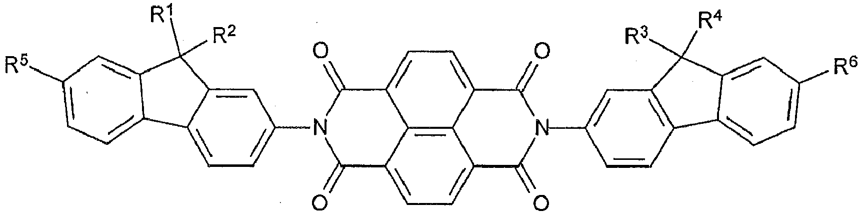 dans laquelle R¹ à R⁶ est choisi indépendamment parmi un hydrogène, un halogène, un alkyle en C₁ à C₂₀, un hétéroalkyle en C₁ à C₂₀, un alkényle en C₁ à C₂₀, un hétéroalkényle en C₁ à C₂₀, un alkinyle en C₁ à C₂₀, un hétéroalkinyle en C₁ à C₂₀, un aryle en C₆ à C₂₀, un hétéroaryle en C₆ à C₂₀, non substitué ou substitué, sature ou insaturé, un carbocycle ou un hétérocycle, saturé ou insaturé qui peuvent être identiques ou différents, deux radicaux R¹ à R⁶ voisins pouvant être également un élément d'un autre groupe carbocyclique ou hétérocyclique saturé ou insaturé, le groupe pouvant comprendre du C, du N, de l'O, du S, du SI et du Se.

2. Cellule solaire organique selon la revendication 1, **caractérisée en ce que** cette dernière est constituée d'une séquence de couches minces et de couches de contact organiques avec au moins une couche de transport (2, 4, 6, 8) dopée et au moins une couche photo-active qui sont placées dans une structure de diodes p-i-n, n-i-p, n-i-M ou M-i-n de respectivement une ou plusieurs couches p, i ou n.

3. Cellule solaire organique selon la revendication 1, **caractérisée en ce que** cette dernière est constituée d'une séquence de couches minces et de couches de contact organiques avec au moins une couche de transport (2, 4, 6, 8) dopée et au moins une couche photo-active qui sont placées dans une structure de diodes p-i-n, n-i-p, n-i-M ou M-i-n de respectivement une ou plusieurs couches p, i ou n, au moins une couche de transport d'électrons (couche n) étant constituée d'au moins, mais pas d'exclusivement un composé N,N-bis(fluorène-2-yl) naphtaline-tétracarboxydiimide de la formule chimique générale

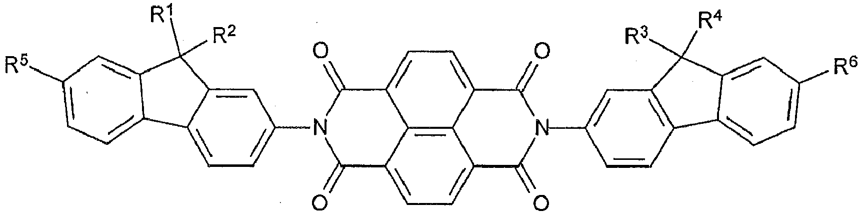

4. Cellule solaire organique selon la revendication 1, **caractérisée en ce que** la cellule solaire organique est une dénommée cellule solaire multiple, c'est-à-dire qu'elle est constituée d'une pile de deux ou de plusieurs cellules solaires organiques individuelles, lesquelles sont reliées par un dénommé « contact de conversion » (5) qui sert à la recombinaison d'électrons et de trous et qui est constitué d'au moins une couche de matières organiques, anorganiques ou d'une combinaison de matières organiques ou anorganiques.

5. Cellule solaire organique selon les revendications 1 - 4, **caractérisée en ce que**, parallèlement à un composé N,N-bis(fluorène-2-yl) naphtaline-tétracarboxydiimide la cellule solaire organique contient également d'autres matières, qui conduisent de préférence des charges négatives (électrons), également appelées « electron transport layer » (ETL).

6. Cellule solaire organique selon les revendications 1 - 4, **caractérisée en ce que** la cellule solaire organique contient des couches anti-diffusion en des métaux ou des métaux de transition (par exemple en Ti, Pd, Cr, sans être restreints à ces derniers).

7. Cellule solaire organique selon les revendications 1 - 4, **caractérisée en ce que** la cellule solaire organique contient des contacts en minces couches métalliques, constituées d'un métal comme par exemple, sans y être restreintes l'aluminium, l'argent, l'or, l'ytterbium, le chrome, le nickel, le magnésium le fer ou une associations de plusieurs métaux.

8. Cellule solaire organique selon les revendications 1 - 4, **caractérisée en ce que** la cellule solaire organique contient des contacts de conversion (8) en minces couches métalliques, en matière anorganiques (par exemple, sans y être restreintes en des dénommés nanocristaux constitués de clusters de taille inférieure à 100 nm d'un métal ou d'une matière anorganique) ou en matières organiques (par exemple, sans y être restreintes en de molécules ou polymères dopés ou non dopés.

9. Cellule solaire organique selon les revendications 1 - 4, **caractérisée en ce que** la cellule solaire organique est fabriquée sur un substrat (0) par exemple, sans y être restreint en verre, en un film d'aluminium, en acier, en une matière textile ou en un film plastique.

10. Cellule solaire organique selon les revendications 1 - 4, **caractérisée en ce que** la cellule solaire organique contient des dénommés dopants de type p, qui font office d'accepteurs d'électrons que l'on utilise par exemple, sans y être restreints dans des couches de transport de trous (HTL).

11. Cellule solaire organique selon les revendications 1 - 4, **caractérisée en ce que** la cellule solaire organique contient des dénommés dopants de type n, qui font office de donateurs d'électrons que l'on utilise par exemple, sans y être restreints dans des couches de transport d'électrons (ETL).

12. Cellule solaire organique selon les revendications 1 - 4, **caractérisée en ce que** la cellule solaire organique contient des séquences de couches en matières fortement dopées, la séquence de couches contenant au moins une matière dopée de type p et au moins une matière dopée de type n et faisant office globalement de contact de conversion de porteurs de charges.

13. Cellule solaire organique selon les revendications 1 - 4, **caractérisée en ce que** la cellule solaire organique contient des matières qui servent à l'encapsulage.

14. Cellule solaire organique selon les revendications 1 - 4, **caractérisée en ce que** la cellule solaire organique contient des couches de couverture pour l'injection de lumière.

15. Procédé destiné à fabriquer une cellule solaire organique selon l'une quelconque des revendications 1 - 14.

16. Procédé destiné à fabriquer une cellule solaire organique selon la revendication 15, **caractérisé en ce qu'**on fabrique la cellule solaire organique ou des parties de celle-ci par évaporation thermique ou par un autre procédé thermique.

17. Procédé destiné à fabriquer une cellule solaire organique selon la revendication 15, **caractérisé en ce qu'**on a fabriqué la cellule solaire organique ou des parties de celle-ci par enduction centrifuge/projection (« spincoating »), immersion (« dip-coating »), par déposition au goutte-à-goutte (« drop-casting »),par raclage (« doctor-blading »), par déposition en phases vapeur par procédés chimiques (« chemical vapour phase déposition », CVPD ou « organic vapour phase deposition », OVPD), par déposition d'électrodes ou par d'autres procédés chimiques, électrochimiques ou chimiques humides.

18. Procédé destiné à fabriquer une cellule solaire organique selon la revendication 15, **caractérisé en ce qu'**on a fabriqué la cellule solaire organique ou des parties de celle-ci par sérigraphie, par impression offset, par impression par jet d'encre ou par d'autres procédés basés sur des impressions.

19. Procédé destiné à fabriquer une cellule solaire organique selon la revendication 15, **caractérisé en ce qu'**on a fabriqué la cellule solaire organique ou des parties de celle-ci par pulvérisation magnétron « magnetron sputtering » ou par d'autres procédés basés sur la pulvérisation cathodique.

20. Procédé destiné à fabriquer une cellule solaire organique selon la revendication 15, **caractérisé en ce qu'**on a fabriqué la cellule solaire organique ou des parties de celle-ci par épitaxie par jet moléculaire ou par des procédés comparables.

21. Procédé destiné à fabriquer une cellule solaire organique selon la revendication 15, **caractérisé en ce qu'**on a fabriqué la cellule solaire organique ou des parties de celle-ci par surlaminage ou par des procédés comparables.

22. Procédé destiné à fabriquer une cellule solaire organique selon la revendication 15, **caractérisé en ce qu'**on a fabriqué la cellule solaire organique ou des parties de celle-ci par des monocouches auto-structurantes (des dénommés « self-assembled monolayers ») ou par des procédés comparables.

23. Procédé destiné à fabriquer une cellule solaire organique selon la revendication 15, **caractérisé en ce qu'**on a fabriqué la cellule solaire organique ou des parties de celle-ci, en utilisant la formule chimique générale 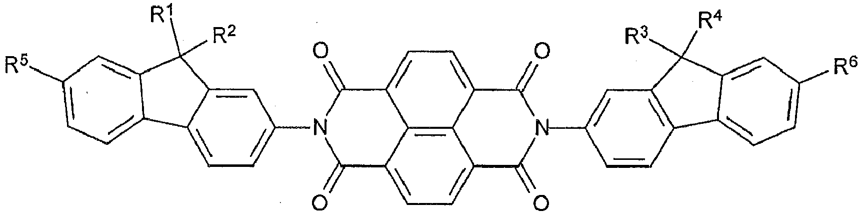 sous la forme d'un monomère qui se polymérise *in situ* sous l'effet de la lumière, de radicaux, de catalyse, sous effet thermique ou par des procédés comparables, pour obtenir une réticulation transversale de la couche.
